(19) Europäisches Patentamt / European Patent Office / Office européen des brevets

(11) **EP 2 947 657 B1**

(12) **EUROPEAN PATENT SPECIFICATION**

(45) Date of publication and mention of the grant of the patent:
**24.10.2018 Bulletin 2018/43**

(51) Int Cl.:
*G10L 19/008* (2013.01)    *G10L 19/04* (2013.01)

(21) Application number: **15176785.2**

(22) Date of filing: **23.03.2011**

(54) **MULTI-CHANNEL AUDIO CODING USING COMPLEX PREDICTION AND REAL INDICATOR**

MEHRKANALIGE AUDIOKODIERUNG MITHILFE EINER KOMPLEXEN PRÄDIKTION UND EINES ECHTEN INDIKATORS

CODAGE AUDIO MULTICANAL AU MOYEN D'UNE PRÉDICTION COMPLEXE ET D'UN INDICATEUR RÉEL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.04.2010 US 322688 P**
**13.07.2010 US 363906 P**
**13.07.2010 EP 10169432**

(43) Date of publication of application:
**25.11.2015 Bulletin 2015/48**

(62) Document number(s) of the earlier application(s) in accordance with Art. 76 EPC:
**11709735.2 / 2 543 038**

(73) Proprietors:
• **Fraunhofer-Gesellschaft zur Förderung der angewandten Forschung e.V.**
**80686 München (DE)**
• **Dolby International AB**
**1101 CN Amsterdam Zuid-Oost (NL)**

(72) Inventors:
• **Purnhagen, Heiko**
**172 65 Sundbyberg (SE)**
• **Carlsson, Pontus**
**168 32 Bromma (SE)**
• **Villemoes, Lars**
**175 56 Järfälla (SE)**
• **Robilliard, Julien**
**90429 Nürnberg (DE)**
• **Neusinger, Matthias**
**91186 Rohr (DE)**
• **Helmrich, Christian**
**91054 Erlangen (DE)**
• **Hilpert, Johannes**
**90411 Nürnberg (DE)**
• **Rettelbach, Nikolaus**
**90427 Nürnberg (DE)**
• **Disch, Sascha**
**90766 Fürth (DE)**
• **Edler, Bernd**
**90766 Fürth (DE)**

(74) Representative: **Zinkler, Franz**
**Schoppe, Zimmermann, Stöckeler Zinkler, Schenk & Partner mbB Patentanwälte Radlkoferstrasse 2 81373 München (DE)**

(56) References cited:
**WO-A1-90/16136**      **WO-A1-2009/141775**
**WO-A1-2011/124608**

• **HEIKO PURNHAGEN ET AL: "Technical description of proposed Unified Stereo Coding in USAC", 90. MPEG MEETING; 26-10-2009 - 30-10-2009; XIAN; (MOTION PICTURE EXPERT GROUP OR ISO/IEC JTC1/SC29/WG11),, 23 October 2009 (2009-10-23), XP030045511,**
• **MAX NEUENDORF (EDITOR): "WD5 of USAC", 90. MPEG MEETING; 26-10-2009 - 30-10-2009; XIAN; (MOTION PICTURE EXPERT GROUP OR ISO/IECJTC1/SC29/WG11), no. N11040, 8 December 2009 (2009-12-08), pages 1-146, XP002632396,**

• PONTUS CARLSSON ET AL: "Technical description of CE on improved stereo coding in USAC", 93. MPEG MEETING; 26-7-2010 - 30-7-2010; GENEVA; (MOTION PICTURE EXPERT GROUP OR ISO/IEC JTC1/SC29/WG11),, 22 July 2010 (2010-07-22), XP030046415,

**Description**

The present invention is related to audio processing and, particularly, to multi-channel audio processing of a multi-channel signal having two or more channel signals.

It is known in the field of multi-channel or stereo processing to apply the so-called mid/side stereo coding. In this concept, a combination of the left or first audio channel signal and the right or second audio channel signal is formed to obtain a mid or mono signal M. Additionally, a difference between the left or first channel signal and the right or second channel signal is formed to obtain the side signal S. This mid/side coding method results in a significant coding gain, when the left signal and the right signal are quite similar to each other, since the side signal will become quite small. Typically, a coding gain of a quantizer/entropy encoder stage will become higher, when the range of values to be quantized/entropy-encoded becomes smaller. Hence, for a PCM or a Huffman-based or arithmetic entropy-encoder, the coding gain increases, when the side signal becomes smaller. There exist, however, certain situations in which the mid/side coding will not result in a coding gain. The situation can occur when the signals in both channels are phase-shifted to each other, for example, by 90°. Then, the mid signal and the side signal can be in a quite similar range and, therefore, coding of the mid signal and the side signal using the entropy-encoder will not result in a coding gain and can even result in an increased bit rate. Therefore, a frequency-selective mid/side coding can be applied in order to deactivate the mid/side coding in bands, where the side signal does not become smaller to a certain degree with respect to the original left signal, for example.

Although the side signal will become zero, when the left and right signals are identical, resulting in a maximum coding gain due to the elimination of the side signal, the situation once again becomes different when the mid signal and the side signal are identical with respect to the shape of the waveform, but the only difference between both signals is their overall amplitudes. In this case, when it is additionally assumed that the side signal has no phase-shift to the mid signal, the side signal significantly increases, although, on the other hand, the mid signal does not decrease so much with respect to its value range. When such a situation occurs in a certain frequency band, then one would again deactivate mid/side coding due to the lack of coding gain. Mid/side coding can be applied frequency-selectively or can alternatively be applied in the time domain.

There exist alternative multi-channel coding techniques which do not rely on a kind of a waveform approach as mid/side coding, but which rely on the parametric processing based on certain binaural cues. Such techniques are known under the term "binaural cue coding", "parametric stereo coding" or "MPEG Surround coding". Here, certain cues are calculated for a plurality of frequency bands. These cues include inter-channel level differences, inter-channel coherence measures, inter-channel time differences and/or inter-channel phase differences. These approaches start from the assumption that a multi-channel impression felt by the listener does not necessarily rely on the detailed waveforms of the two channels, but relies on the accurate frequency-selectively provided cues or inter-channel information. This means that, in a rendering machine, care has to be taken to render multi-channel signals which accurately reflect the cues, but the waveforms are not of decisive importance.

This approach can be complex particularly in the case, when the decoder has to apply a decorrelation processing in order to artificially create stereo signals which are decorrelated from each other, although all these channels are derived from one and the same downmix channel. Decorrelators for this purpose are, depending on their implementation, complex and may introduce artifacts particularly in the case of transient signal portions. Additionally, in contrast to waveform coding, the parametric coding approach is a lossy coding approach which inevitably results in a loss of information not only introduced by the typical quantization but also introduced by looking on the binaural cues rather than the particular waveforms. This approach results in very low bit rates but may include quality compromises.

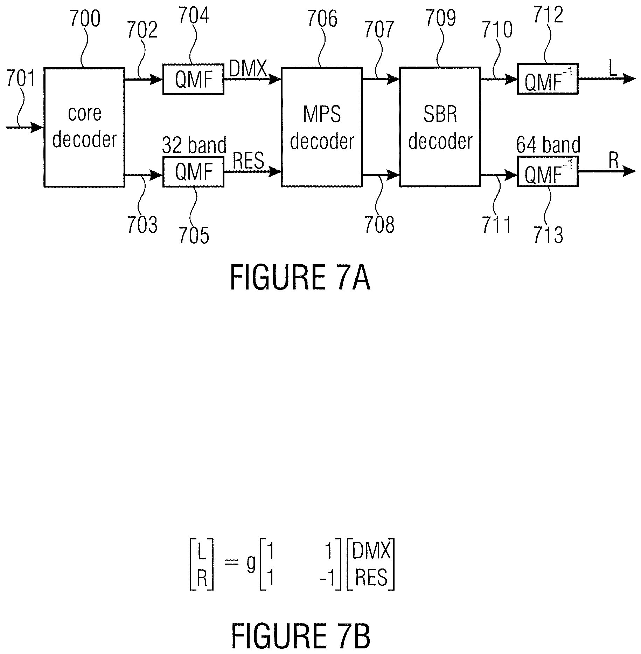

There exist recent developments for unified speech and audio coding (USAC) illustrated in Fig. 7a. A core decoder 700 performs a decoding operation of the encoded stereo signal at input 701, which can be mid/side encoded. The core decoder outputs a mid signal at line 702 and a side or residual signal at line 703. Both signals are transformed into a QMF domain by QMF filter banks 704 and 705. Then, an MPEG Surround decoder 706 is applied to generate a left channel signal 707 and a right channel signal 708. These low-band signals are subsequently introduced into a spectral band replication (SBR) decoder 709, which produces broad-band left and right signals on the lines 710 and 711, which are then transformed into a time domain by the QMF synthesis filter banks 712, 713 so that broad-band left and right signals L, R are obtained.

Fig. 7b illustrates the situation when the MPEG Surround decoder 706 would perform a mid/side decoding. Alternatively, the MPEG Surround decoder block 706 could perform a binaural cue based parametric decoding for generating stereo signals from a single mono core decoder signal. Naturally, the MPEG Surround decoder 706 could also generate a plurality of low band output signals to be input into the SBR decoder block 709 using parametric information such as inter-channel level differences, inter-channel coherence measures or other such inter-channel information parameters.

When the MPEG Surround decoder block 706 performs the mid/side decoding illustrated in Fig. 7b, a real-gain factor g can be applied and DMX/RES and L/R are downmix/residual and left/right signals, respectively, represented in the complex hybrid QMF domain.

Using a combination of a block 706 and a block 709 causes only a small increase in computational complexity compared to a stereo decoder used as a basis, because the complex QMF representation of the signal is already available as part of the SBR decoder. In a non-SBR configuration, however, QMF-based stereo coding, as proposed in the context of USAC, would result in a significant increase in computational complexity because of the necessary QMF banks which would require in this example 64-band analysis banks and 64-band synthesis banks. These filter banks would have to be added only for the purpose of stereo coding.

In the MPEG USAC system under development, however, there also exist coding modes at high bit rates where SBR typically is not used.

The two following MPEG USAC documents are exemplary of multichannel audio (de)coding schemes whereby a difference signal is estimated from a downmix/sum/mono signal by means of a complex-valued prediction coefficient: HEIKO PURNHAGEN ET AL: "Technical description of proposed Unified Stereo Coding in USAC",90. MPEG MEETING; 26-10-2009 - 30-10-2009; XIAN; (MOTION PICTURE EXPERT GROUP OR ISO/IEC JTC1/ SC29/WG11), no. M16921, 23 October 2009 (2009-10-23).

MAX NEUENDORF (EDITOR): "WD5 of USAC",90. MPEG MEETING; 26-10-2009 - 30-10-2009; XIAN; (MOTION PICTURE EXPERT GROUP OR ISO/IECJTC1/SC29/WG11), no. N11040, 8 December 2009 (2009-12-08), pages 1-146.

Post-published WO 2011/124608 A1 discloses methods and devices for stereo encoding and decoding using complex prediction in the frequency domain. In one embodiment, a decoding method, for obtaining an output stereo signal from an input stereo signal encoded by complex prediction coding and comprising first frequency-domain representations of two input channels, comprises the upmixing steps of: (i) computing a second frequency-domain representation of a first input channel; and (ii) computing an output channel on the basis of the first and second frequency-domain representations of the first input channel, the first frequency-domain representation of the second input channel and a complex prediction coefficient. The upmixing can be suspended responsive to control data.

WO 2009/141775 A1 discloses a parametric stereo upmix apparatus generating a left signal and a right signal from a mono downmix signal based on spatial parameters. Said parametric stereo upmix being characterized in that it comprises a means for predicting a difference signal comprising a difference between the left signal and the right signal based on the mono downmix signal scaled with a prediction coefficient. Said prediction coefficient is derived from the spatial parameters. Said parametric stereo upmix apparatus further comprises an arithmetic means for deriving the left signal and the right signal based on a sum and a difference of the mono downmix signal and said difference signal.

It is an objective of the present invention to provide an improved audio processing concept which, on the one hand, yields high coding gain and, on the other hand, results in a good audio quality and/or reduced computational complexity.

This objective is achieved by an audio decoder in accordance with claim 1, an audio encoder in accordance with claim 7, a method of audio decoding in accordance with claim 14, a method of audio encoding in accordance with claim 15, or a computer program in accordance with claim 16.

The present invention relies on the finding that a coding gain of the high quality waveform coding approach can be significantly enhanced by a prediction of a second combination signal using a first combination signal, where both combination signals are derived from the original channel signals using a combination rule such as the mid/side combination rule. It has been found that this prediction information is calculated by a predictor in an audio encoder so that an optimization target is fulfilled, incurs only a small overhead, but results in a significant decrease of bit rate required for the side signal without losing any audio quality, since the inventive prediction is nevertheless a waveform-based coding and not a parameter-based stereo or multi-channel coding approach. In order to reduce computational complexity, it is preferred to perform frequency-domain encoding, where the prediction information is derived from frequency domain input data in a band-selective way. The conversion algorithm for converting the time domain representation into a spectral representation is preferably a critically sampled process such as a modified discrete cosine transform (MDCT) or a modified discrete sine transform (MDST), which is different from a complex transform in that only real values or only imaginary values are calculated, while, in a complex transform, real and complex values of a spectrum are calculated resulting in 2-times oversampling.

Preferably, a transform based on aliasing introduction and cancellation is used. The MDCT, in particular, is such a transform and allows a cross-fading between subsequent blocks without any overhead due to the well-known time domain aliasing cancellation (TDAC) property which is obtained by overlap-add-processing on the decoder side.

Preferably, the prediction information calculated in the encoder, transmitted to the decoder and used in the decoder comprises an imaginary part which can advantageously reflect phase differences between the two audio channels in arbitrarily selected amounts between 0° and 360°. Computational complexity is significantly reduced when only a real-valued transform or, in general, a transform is applied which either provides a real spectrum only or provides an imaginary spectrum only. In order to make use of this imaginary prediction information which indicates a phase shift between a certain band of the left signal and a corresponding band of the right signal, a real-to-imaginary converter or, depending on the implementation of the transform, an imaginary-to-real converter is provided in the decoder in order to calculate a prediction residual signal from the first combination signal, which is phase-rotated with respect to the original combination signal. This phase-rotated prediction residual signal can then be combined with the prediction residual signal transmitted in the bit stream to regenerate a side signal which, finally, can be combined with the mid signal to obtain the decoded left channel in a certain band and the decoded right channel in this band.

To increase audio quality, the same real-to-imaginary or imaginary-to-real converter which is applied on the decoder side is implemented on the encoder side as well, when the prediction residual signal is calculated in the encoder.

The present invention is advantageous in that it provides an improved audio quality and a reduced bit rate compared to systems having the same bit rate or having the same audio quality.

Additionally, advantages with respect to computational efficiency of unified stereo coding useful in the MPEG USAC system at high bit rates are obtained, where SBR is typically not used. Instead of processing the signal in the complex hybrid QMF domain, these approaches implement residual-based predictive stereo coding in the native MDCT domain of the underlying stereo transform coder.

Examples comprise an apparatus or method for generating a stereo signal by complex prediction in the MDCT domain, wherein the complex prediction is done in the MDCT domain using a real-to-complex transform, where this stereo signal can either be an encoded stereo signal on the encoder-side or can alternatively be a decoded/transmitted stereo signal, when the apparatus or method for generating the stereo signal is applied on the decoder-side.

Preferred embodiments of the present invention are subsequently discussed with respect to the accompanying drawings, in which:

Fig. 1        is a diagram of an audio decoder;
Fig. 2        is a block diagram of an audio encoder;
Fig. 3a       illustrates an implementation of the encoder calculator of Fig. 2;
Fig. 3b       illustrates an alternative implementation of the encoder calculator of Fig. 2;
Fig. 3c       illustrates a mid/side combination rule to be applied on the encoder side;
Fig. 4a       illustrates an implementation of the decoder calculator of Fig. 1;
Fig. 4b       illustrates an alternative implementation of the decoder calculator in form of a matrix calculator;
Fig. 4c       illustrates a mid/side inverse combination rule corresponding to the combination rule illustrated in Fig. 3c;
Fig. 5a       illustrates an embodiment of an audio encoder operating in the frequency domain which is preferably a real-valued frequency domain;
Fig. 5b       illustrates an implementation of an audio decoder operating in the frequency domain;
Fig. 6a       illustrates an alternative implementation of an audio encoder operating in the MDCT domain and using a real-to-imaginary transform in accordance with a preferred embodiment of the invention;
Fig. 6b       illustrates an audio decoder operating in the MDCT domain and using a real-to-imaginary transform in accordance with a preferred embodiment of the invention;
Fig. 7a       illustrates an audio postprocessor using a stereo decoder and a subsequently connected SBR decoder;
Fig. 7b       illustrates a mid/side upmix matrix;
Fig. 8a       illustrates a detailed view on the MDCT block in Fig. 6a;
Fig. 8b       illustrates a detailed view on the MDCT$^{-1}$ block of Fig. 6b;
Fig. 9a       illustrates an implementation of an optimizer operating on reduced resolution with respect to the MDCT output;
Fig. 9b       illustrates a representation of an MDCT spectrum and the corresponding lower resolution bands in which the prediction information is calculated;
Fig. 10a      illustrates an implementation of the real-to-imaginary transformer in Fig. 6a or Fig. 6b; and
Fig. 10b      illustrates a possible implementation of the imaginary spectrum calculator of Fig. 10a.

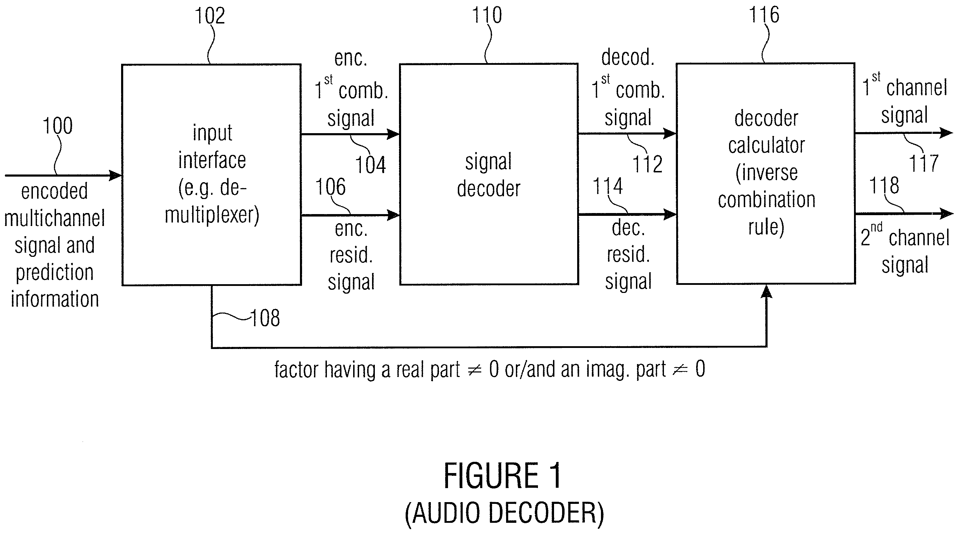

Fig. 1 illustrates an audio decoder for decoding an encoded multi-channel audio signal obtained at an input line 100. The encoded multi-channel audio signal comprises an encoded first combination signal generated using a combination rule for combining a first channel signal and a second channel signal representing the multi-channel audio signal, an encoded prediction residual signal and prediction information. The encoded multi-channel signal can be a data stream such as a bitstream which has the three components in a multiplexed form. Additional side information can be included in the encoded multi-channel signal on line 100. The signal is input into an input interface 102. The input interface 102 can be implemented as a data stream demultiplexer which outputs the encoded first combination signal on line 104, the encoded residual signal on line 106 and the prediction information on line 108. Preferably, the prediction information is a factor having a real part not equal to zero and/or an imaginary part different from zero. The encoded combination signal and the encoded residual signal are input into a signal decoder 110 for decoding the first combination signal to obtain a decoded first combination signal on line 112. Additionally, the signal decoder 110 is configured for decoding the encoded residual signal to obtain a decoded residual signal on line 114. Depending on the encoding processing on an audio encoder side, the signal decoder may comprise an entropy-decoder such as a Huffman decoder, an arithmetic decoder or any other entropy-decoder and a subsequently connected dequantization stage for performing a dequantization operation matching with a quantizer operation in an associated audio encoder. The signals on line 112 and 114 are input into a decoder calculator 115, which outputs the first channel signal on line 117 and a second channel signal on line 118, where these two signals are stereo signals or two channels of a multi-channel audio signal. When, for example, the multi-channel audio signal comprises five channels, then the two signals are two channels from the multi-channel signal. In order to fully encode such a multi-channel signal having five channels, two decoders illustrated in Fig. 1 can be applied, where the first decoder processes the left channel and the right channel, the second decoder processes the left surround channel and the right surround channel, and a third mono decoder would be used for performing a mono-encoding of the center channel. Other groupings, however, or combinations of wave form coders and parametric coders can be applied as well. An alternative way to generalize the prediction scheme to more than two channels would be to treat three (or more) signals at the same time, i.e., to predict a 3rd combination signal from a 1st and a 2nd signal using two prediction coefficients, very similarly to the "two-to-three" module in MPEG Surround.

The decoder calculator 116 is configured for calculating a decoded multi-channel signal having the decoded first channel signal 117 and the decoded second channel signal 118 using the decoded residual signal 114, the prediction information 108 and the decoded first combination signal 112. Particularly, the decoder calculator 116 is configured to operate in such a way that the decoded first channel signal and the decoded second channel signal are at least an approximation of a first channel signal and a second channel signal of the multi-channel signal input into a corresponding encoder, which are combined by the combination rule when generating the first combination signal and the prediction residual signal. Specifically, the prediction information on line 108 comprises a real-valued part different from zero and/or an imaginary part different from zero.

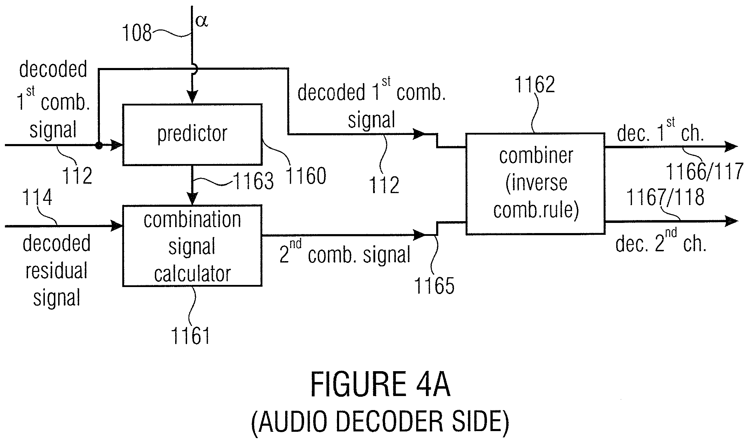

The decoder calculator 116 can be implemented in different manners. A first implementation is illustrated in Fig. 4a. This implementation comprises a predictor 1160, a combination signal calculator 1161 and a combiner 1162. The predictor receives the decoded first combination signal 112 and the prediction information 108 and outputs a prediction signal 1163. Specifically, the predictor 1160 is configured for applying the prediction information 108 to the decoded first combination signal 112 or a signal derived from the decoded first combination signal. The derivation rule for deriving the signal to which the prediction information 108 is applied may be a real-to-imaginary transform, or equally, an imaginary-to-real transform or a weighting operation, or depending on the implementation, a phase shift operation or a combined weighting/phase shift operation. The prediction signal 1163 is input together with the decoded residual signal into the combination signal calculator 1161 in order to calculate the decoded second combination signal 1165. The signals 112 and 1165 are both input into the combiner 1162, which combines the decoded first combination signal and the second combination signal to obtain the decoded multi-channel audio signal having the decoded first channel signal and the decoded second channel signal on output lines 1166 and 1167, respectively. Alternatively, the decoder calculator is implemented as a matrix calculator 1168 which receives, as input, the decoded first combination signal or signal M, the decoded residual signal or signal D and the prediction information $\alpha$ 108. The matrix calculator 1168 applies a transform matrix illustrated as 1169 to the signals M, D to obtain the output signals L, R, where L is the decoded first channel signal and R is the decoded second channel signal.

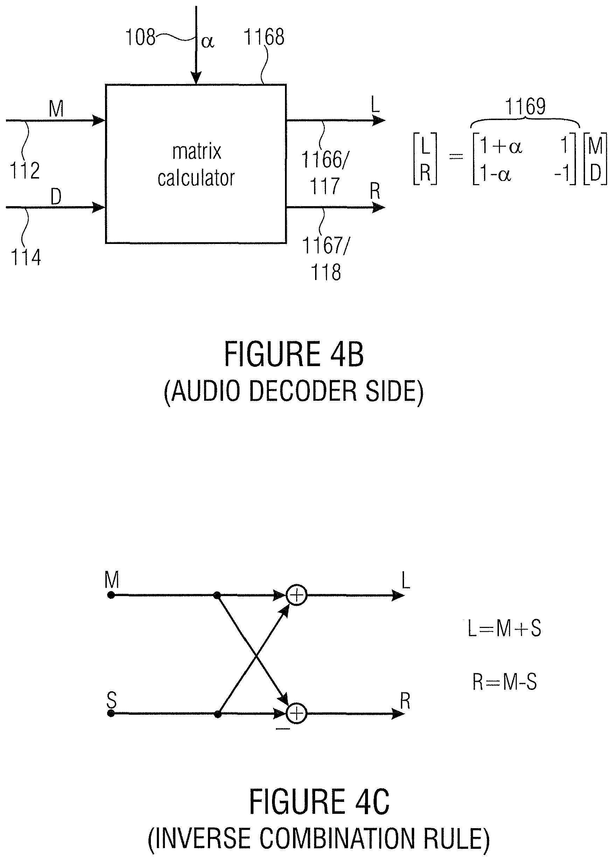

The notation in Fig. 4b resembles a stereo notation with a left channel L and a right channel R. This notation has been applied in order to provide an easier understanding, but it is clear to those skilled in the art that the signals L, R can be any combination of two channel signals in a multi-channel signal having more than two channel signals. The matrix operation 1169 unifies the operations in blocks 1160, 1161 and 1162 of Fig. 4a into a kind of "single-shot" matrix calculation, and the inputs into the Fig. 4a circuit and the outputs from the Fig. 4a circuit are identical to the inputs into the matrix calculator 1168 or the outputs from the matrix calculator 1168.

Fig. 4c illustrates an example for an inverse combination rule applied by the combiner 1162 in Fig. 4a. Particularly, the combination rule is similar to the decoder-side combination rule in well-known mid/side coding, where L = M + S, and R = M - S. It is to be understood that the signal S used by the inverse combination rule in Fig. 4c is the signal calculated by the combination signal calculator, i.e. the combination of the prediction signal on line 1163 and the decoded residual signal on line 114. It is to be understood that in this specification, the signals on lines are sometimes named by the reference numerals for the lines or are sometimes indicated by the reference numerals themselves, which have been attributed to the lines. Therefore, the notation is such that a line having a certain signal is indicating the signal itself. A line can be a physical line in a hardwired implementation. In a computerized implementation, however, a physical line does not exist, but the signal represented by the line is transmitted from one calculation module to the other calculation module.

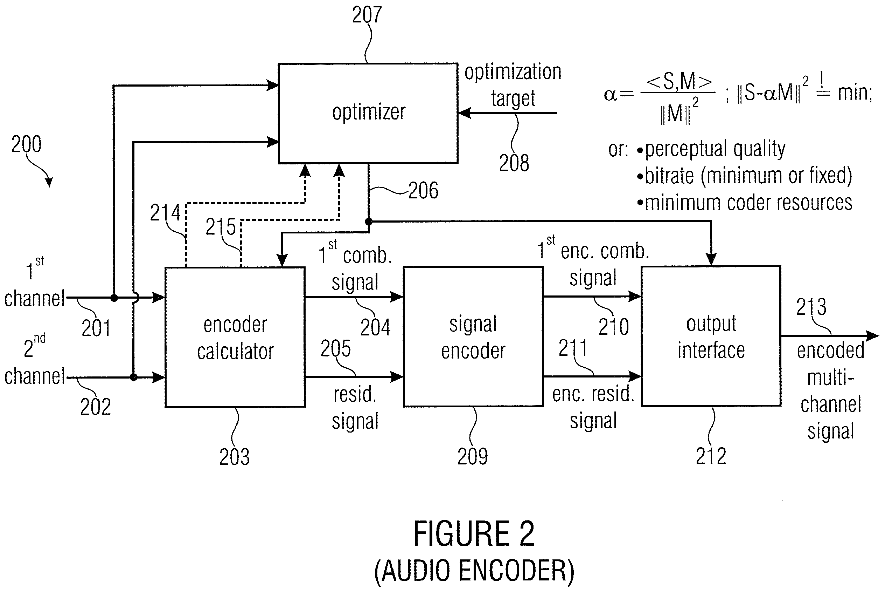

Fig. 2 illustrates an audio encoder for encoding a multi-channel audio signal 200 having two or more channel signals, where a first channel signal is illustrated at 201 and a second channel is illustrated at 202. Both signals are input into an encoder calculator 203 for calculating a first combination signal 204 and a prediction residual signal 205 using the first channel signal 201 and the second channel signal 202 and the prediction information 206, so that the prediction residual signal 205, when combined with a prediction signal derived from the first combination signal 204 and the prediction information 206 results in a second combination signal, where the first combination signal and the second combination signal are derivable from the first channel signal 201 and the second channel signal 202 using a combination rule.

The prediction information is generated by an optimizer 207 for calculating the prediction information 206 so that the prediction residual signal fulfills an optimization target 208. The first combination signal 204 and the residual signal 205 are input into a signal encoder 209 for encoding the first combination signal 204 to obtain an encoded first combination signal 210 and for encoding the residual signal 205 to obtain an encoded residual signal 211. Both encoded signals 210, 211 are input into an output interface 212 for combining the encoded first combination signal 210 with the encoded prediction residual signal 211 and the prediction information 206 to obtain an encoded multi-channel signal 213, which is similar to the encoded multi-channel signal 100 input into the input interface 102 of the audio decoder illustrated in Fig. 1.

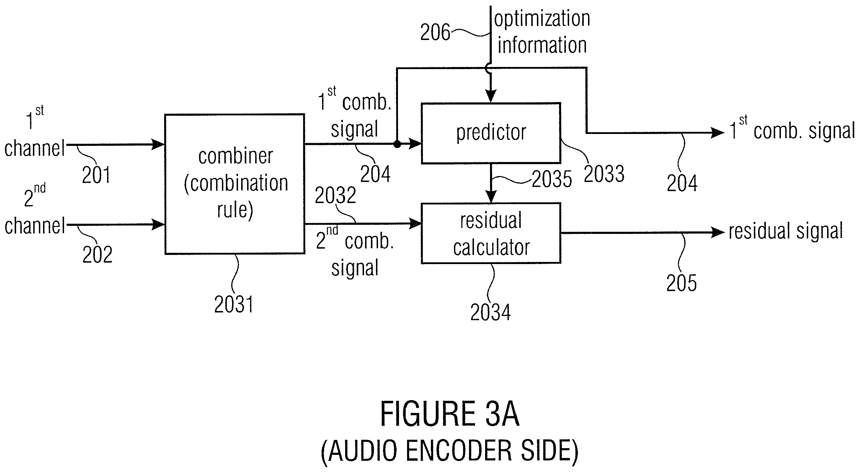

Depending on the implementation, the optimizer 207 receives either the first channel signal 201 and the second channel signal 202, or as illustrated by lines 214 and 215, the first combination signal 214 and the second combination signal 215 derived from a combiner 2031 of Fig. 3a, which will be discussed later.

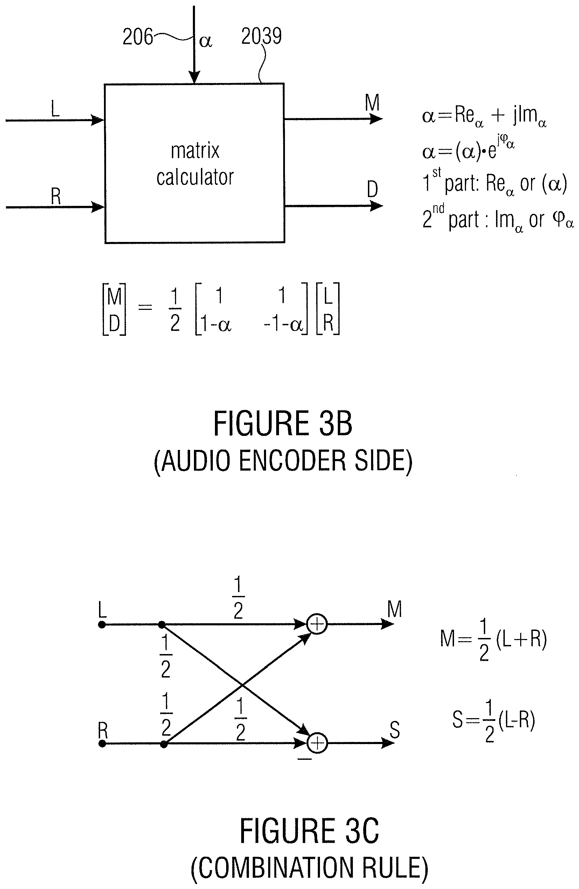

A preferred optimization target is illustrated in Fig. 2, in which the coding gain is maximized, i.e. the bit rate is reduced as much as possible. In this optimization target, the residual signal D is minimized with respect to $\alpha$. This means, in other words, that the prediction information $\alpha$ is chosen so that $||S - \alpha M||^2$ is minimized. This results in a solution for $\alpha$ illustrated in Fig. 2. The signals S, M are given in a block-wise manner and are preferably spectral domain signals, where the notation $||...||$ means the 2-norm of the argument, and where $<...>$ illustrates the dot product as usual. When the first channel signal 201 and the second channel signal 202 are input into the optimizer 207, then the optimizer would have to apply the combination rule, where an exemplary combination rule is illustrated in Fig. 3c. When, however, the first combination signal 214 and the second combination signal 215 are input into the optimizer 207, then the optimizer 207 does not need to implement the combination rule by itself.

Other optimization targets may relate to the perceptual quality. An optimization target can be that a maximum perceptual quality is obtained. Then, the optimizer would require additional information from a perceptual model. Other implementations of the optimization target may relate to obtaining a minimum or a fixed bit rate. Then, the optimizer 207 would be implemented to perform a quantization/entropy-encoding operation in order to determine the required bit rate for certain $\alpha$ values so that the $\alpha$ can be set to fulfill the requirements such as a minimum bit rate, or alternatively, a fixed bit rate. Other implementations of the optimization target can relate to a minimum usage of encoder or decoder resources. In case of an implementation of such an optimization target, information on the required resources for a certain optimization would be available in the optimizer 207. Additionally, a combination of these optimization targets or other optimization targets can be applied for controlling the optimizer 207 which calculates the prediction information 206.

The encoder calculator 203 in Fig. 2 can be implemented in different ways, where an exemplary first implementation is illustrated in Fig. 3a, in which an explicit combination rule is performed in the combiner 2031. An alternative exemplary implementation is illustrated in Fig. 3b, where a matrix calculator 2039 is used. The combiner 2031 in Fig. 3a may be implemented to perform the combination rule illustrated in Fig. 3c, which is exemplarily the well-known mid/side encoding rule, where a weighting factor of 0.5 is applied to all branches. However, other weighting factors or no weighting factors at all can be implemented depending on the implementation. Additionally, it is to be noted that other combination rules such as other linear combination rules or non-linear combination rules can be applied, as long as there exists a corresponding inverse combination rule which can be applied in the decoder combiner 1162 illustrated in Fig. 4a, which applies a combination rule that is inverse to the combination rule applied by the encoder. Any invertible prediction rule can be used, since the influence on the waveform is "balanced" by the prediction, i.e. any error is included in the transmitted residual signal, since the prediction operation performed by the optimizer 207 in combination with the encoder calculator 203 is a waveform-conserving process.

The combiner 2031 outputs the first combination signal 204 and a second combination signal 2032. The first combination signal is input into a predictor 2033, and the second combination signal 2032 is input into the residual calculator 2034. The predictor 2033 calculates a prediction signal 2035, which is combined with the second combination signal 2032 to finally obtain the residual signal 205. Particularly, the combiner 2031 is configured for combining the two channel signals 201 and 202 of the multi-channel audio signal in two different ways to obtain the first combination signal 204 and the second combination signal 2032, where the two different ways are illustrated in an exemplary illustration in Fig. 3c. The predictor 2033 is configured for applying the prediction information to the first combination signal 204 or a signal derived from the first combination signal to obtain the prediction signal 2035. The signal derived from the combination signal can be derived by any non-linear or linear operation, where a real-to-imaginary transform/ imaginary-to-real transform is preferred, which can be implemented using a linear filter such as an FIR filter performing weighted additions of certain values.

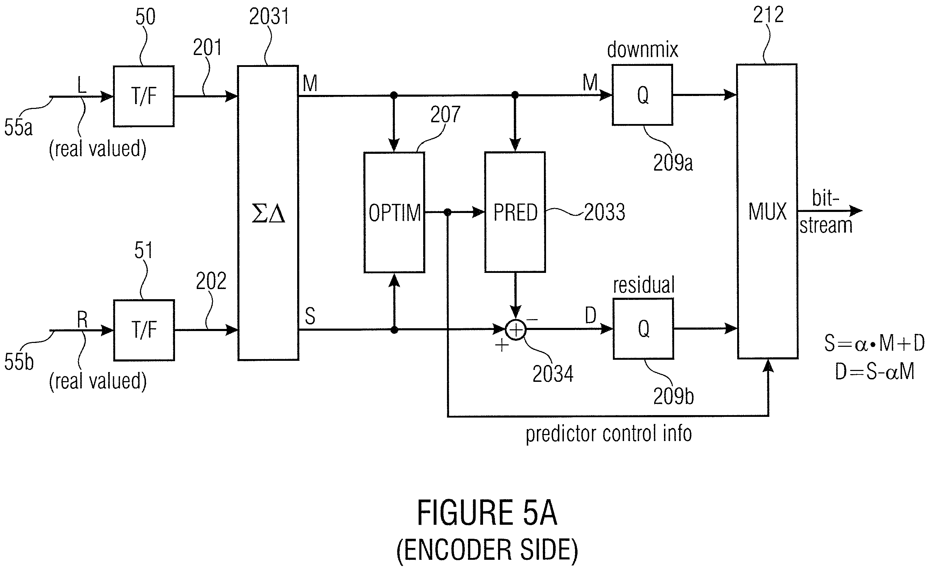

The residual calculator 2034 in Fig. 3a may perform a subtraction operation so that the prediction signal is subtracted from the second combination signal. However, other operations in the residual calculator are possible. Correspondingly, the combination signal calculator 1161 in Fig. 4a may perform an addition operation where the decoded residual signal 114 and the prediction signal 1163 are added together to obtain the second combination signal 1165. Fig. 5a illustrates a preferred implementation of an audio encoder. Compared to the audio encoder illustrated in Fig. 3a, the first channel signal 201 is a spectral representation of a time domain first channel signal 55a. Correspondingly, the second channel signal 202 is a spectral representation of a time domain channel signal 55b. The conversion from the time domain into the spectral representation is performed by a time/frequency converter 50 for the first channel signal and a time/frequency converter 51 for the second channel signal. Preferably, but not necessarily, the spectral converters 50, 51 are implemented as real-valued converters. The conversion algorithm can be a discrete cosine transform, an FFT transform, where only the real-part is used, an MDCT or any other transform providing real-valued spectral values. Alternatively, both transforms can be implemented as an imaginary transform, such as a DST, an MDST or an FFT where only the imaginary part is used and the real part is discarded. Any other transform only providing imaginary values can be used as well. One purpose of using a pure real-valued transform or a pure imaginary transform is computational complexity, since, for each spectral value, only a single value such as magnitude or the real part has to be processed, or, alternatively, the phase or the imaginary part. In contrast to a fully complex transform such as an FFT, two values, i.e., the real part and the imaginary part for each spectral line would have to be processed which is an increase of computational complexity by a factor of at least 2. Another reason for using a real-valued transform here is that such a transform is usually critically sampled, and hence provides a suitable (and commonly used) domain for signal quantization and entropy coding (the standard "perceptual audio coding" paradigm implemented in "MP3", AAC, or similar audio coding systems).

Fig. 5a additionally illustrates the residual calculator 2034 as an adder which receives the side signal at its "plus" input and which receives the prediction signal output by the predictor 2033 at its "minus" input. Additionally, Fig. 5a illustrates the situation that the predictor control information is forwarded from the optimizer to the multiplexer 212 which outputs a multiplexed bit stream representing the encoded multi-channel audio signal. Particularly, the prediction operation is performed in such a way that the side signal is predicted from the mid signal as illustrated by the Equations to the right of Fig. 5a.

Preferably, the predictor control information 206 is a factor as illustrated to the right in Fig. 3b. In an embodiment in which the prediction control information only comprises a real portion such as the real part of a complex-valued $\alpha$ or a magnitude of the complex-valued $\alpha$, where this portion corresponds to a factor different from zero, a significant coding gain can be obtained when the mid signal and the side signal are similar to each other due to their waveform structure, but have different amplitudes.

When, however, the prediction control information only comprises a second portion which can be the imaginary part of a complex-valued factor or the phase information of the complex-valued factor, where the imaginary part or the phase information is different from zero, the present invention achieves a significant coding gain for signals which are phase shifted to each other by a value different from 0° or 180°, and which have, apart from the phase shift, similar waveform characteristics and similar amplitude relations.

Preferably, a prediction control information is complex-valued. Then, a significant coding gain can be obtained for signals being different in amplitude and being phase shifted. In a situation in which the time/frequency transforms provide complex spectra, the operation 2034 would be a complex operation in which the real part of the predictor control information is applied to the real part of the complex spectrum M and the imaginary part of the complex prediction information is applied to the imaginary part of the complex spectrum. Then, in adder 2034, the result of this prediction operation is a predicted real spectrum and a predicted imaginary spectrum, and the predicted real spectrum would be subtracted from the real spectrum of the side signal S (band-wise), and the predicted imaginary spectrum would be subtracted from the imaginary part of the spectrum of S to obtain a complex residual spectrum D.

The time-domain signals L and R are real-valued signals, but the frequency-domain signals can be real- or complex-valued. When the frequency-domain signals are real-valued, then the transform is a real-valued transform. When the frequency domain signals are complex, then the transform is a complex-valued transform. This means that the input to the time-to-frequency and the output of the frequency-to-time transforms are real-valued, while the frequency domain signals could e.g. be complex-valued QMF-domain signals.

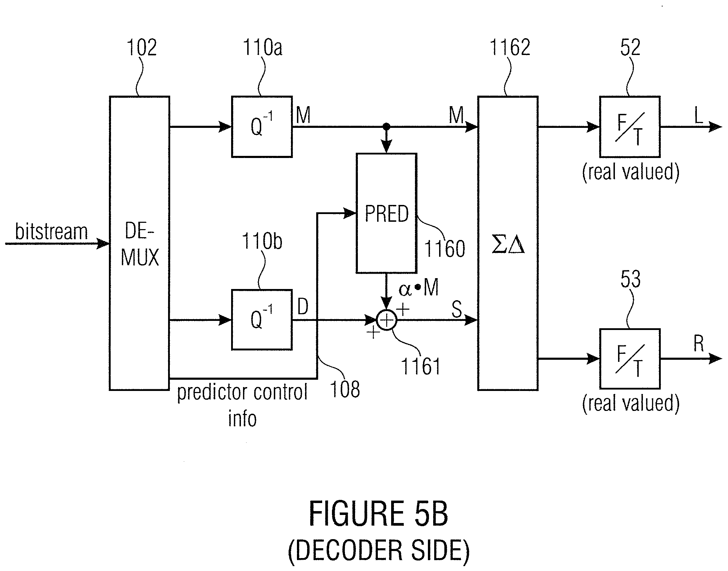

Fig. 5b illustrates an audio decoder corresponding to the audio encoder illustrated in Fig. 5a. Similar elements with respect to the Fig. 1 audio decoder have similar reference numerals.

The bitstream output by bitstream multiplexer 212 in Fig. 5a is input into a bitstream demultiplexer 102 in Fig. 5b. The bitstream demultiplexer 102 demultiplexes the bitstream into the downmix signal M and the residual signal D. The downmix signal M is input into a dequantizer 110a. The residual signal D is input into a dequantizer 110b. Additionally, the bitstream demultiplexer 102 demultiplexes a predictor control information 108 from the bitstream and inputs same into the predictor 1160. The predictor 1160 outputs a predicted side signal $\alpha \cdot$ M and the combiner 1161 combines the residual signal output by the dequantizer 110b with the predicted side signal in order to finally obtain the reconstructed side signal S. The signal is then input into the combiner 1162 which performs, for example, a sum/difference processing, as illustrated in Fig. 4c with respect to the mid/side encoding. Particularly, block 1162 performs an (inverse) mid/side decoding to obtain a frequency-domain representation of the left channel and a frequency-domain representation of the right channel. The frequency-domain representation is then converted into a time domain representation by corresponding frequency/time converters 52 and 53.

Depending on the implementation of the system, the frequency/time converters 52, 53 are real-valued frequency/time converters when the frequency-domain representation is a real-valued representation, or complex-valued frequency/time converters when the frequency-domain representation is a complex-valued representation.

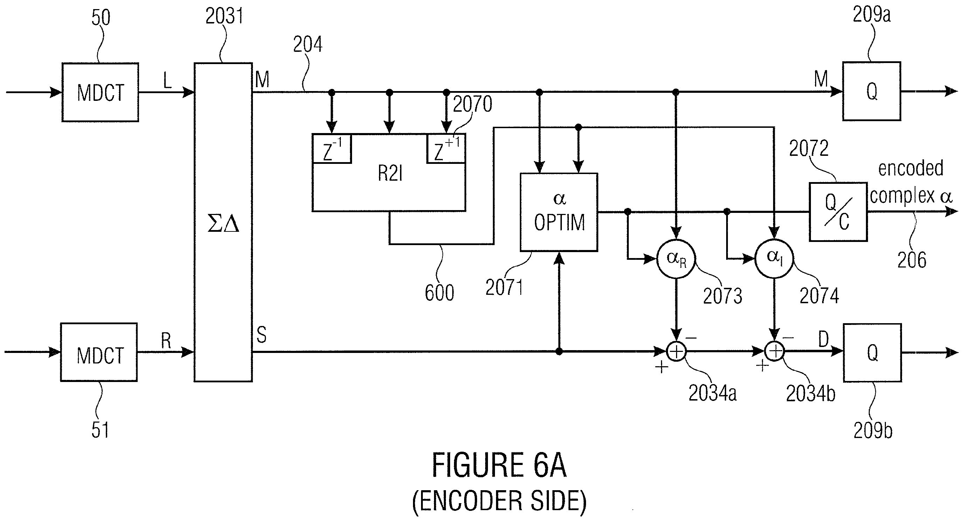

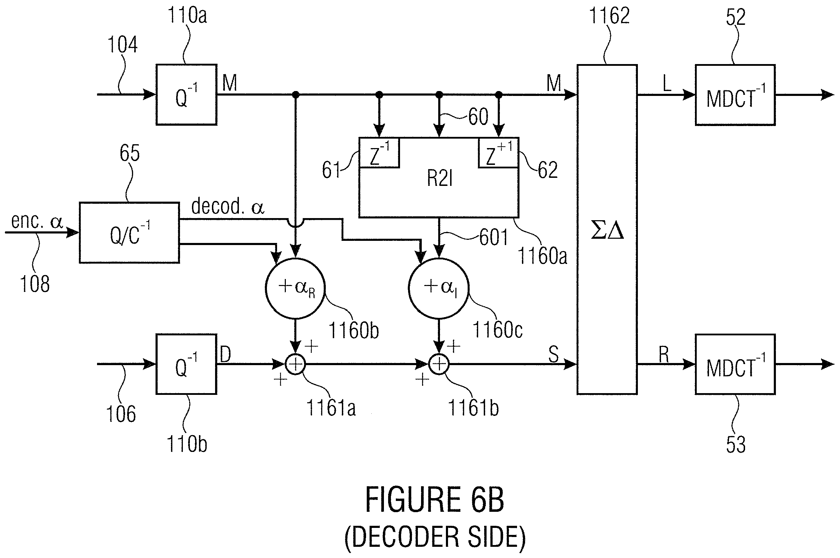

For increasing efficiency, however, performing a real-valued transform is preferred as illustrated in another implementation in Fig. 6a for the encoder and Fig. 6b for the decoder. The real-valued transforms 50 and 51 are implemented by an MDCT. Additionally, the prediction information is calculated as a complex value having a real part and an imaginary part. Since both spectra M, S are real-valued spectra, and since, therefore, no imaginary part of the spectrum exists, a real-to-imaginary converter 2070 is provided which calculates an estimated imaginary spectrum 600 from the real-valued spectrum of signal M. This real-to-imaginary transformer 2070 is a part of the optimizer 207, and the imaginary spectrum 600 estimated by block 2070 is input into the $\alpha$ optimizer stage 2071 together with the real spectrum M in order to calculate the prediction information 206, which now has a real-valued factor indicated at 2073 and an imaginary factor indicated at 2074. Now, in accordance with this embodiment, the real-valued spectrum of the first combination signal M is multiplied by the real part $\alpha_R$ 2073 to obtain the prediction signal which is then subtracted from the real-valued side spectrum. Additionally, the imaginary spectrum 600 is multiplied by the imaginary part $\alpha_I$ illustrated at 2074 to obtain the further prediction signal, where this prediction signal is then subtracted from the real-valued side spectrum as indicated at 2034b. Then, the prediction residual signal D is quantized in quantizer 209b, while the real-valued spectrum of M is quantized/encoded in block 209a. Additionally, it is preferred to quantize and encode the prediction information $\alpha$ in the quantizer/entropy encoder 2072 to obtain the encoded complex $\alpha$ value which is forwarded to the bit stream multiplexer 212 of Fig. 5a, for example, and which is finally input into a bit stream as the prediction information.

Concerning the position of the quantization/coding (Q/C) module 2072 for $\alpha$, it is noted that the multipliers 2073 and 2074 preferably use exactly the same (quantized) $\alpha$ that will be used in the decoder as well. Hence, one could move 2072 directly to the output of 2071, or one could consider that the quantization of $\alpha$ is already taken into account in the optimization process in 2071.

Although one could calculate a complex spectrum on the encoder-side, since all information is available, it is preferred to perform the real-to-complex transform in block 2070 in the encoder so that similar conditions with respect to a decoder illustrated in Fig. 6b are produced. The decoder receives a real-valued encoded spectrum of the first combination signal and a real-valued spectral representation of the encoded residual signal. Additionally, an encoded complex prediction information is obtained at 108, and an entropy-decoding and a dequantization is performed in block 65 to obtain the real part $\alpha_R$ illustrated at 1160b and the imaginary part $\alpha_I$ illustrated at 1160c. The mid signals output by weighting elements 1160b and 1160c are added to the decoded and dequantized prediction residual signal. Particularly, the spectral values input into weighter 1160c, where the imaginary part of the complex prediction factor is used as the weighting factor, are derived from the real-valued spectrum M by the real-to-imaginary converter 1160a, which is preferably implemented in the same way as block 2070 from Fig. 6a relating to the encoder side. On the decoder-side, a complex-valued representation of the mid signal or the side signal is not available, which is in contrast to the encoder-side. The reason is that only encoded real-valued spectra have been transmitted from the encoder to the decoder due to bit rates and complexity reasons.

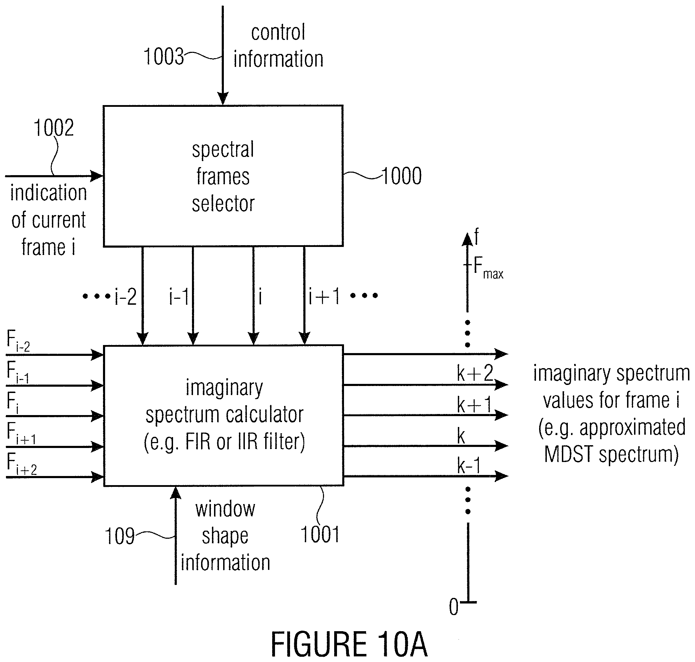

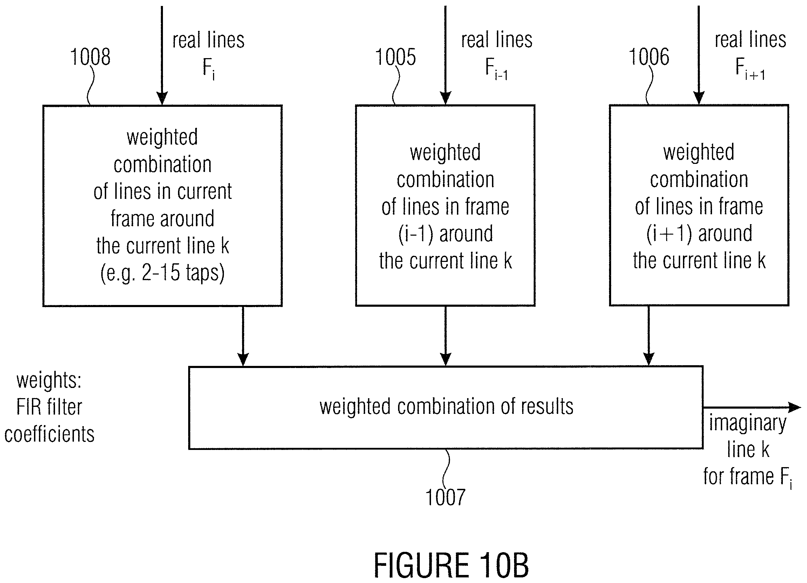

The real-to-imaginary transformer 1160a or the corresponding block 2070 of Fig. 6a can be implemented as published in WO 2004/013839 A1 or WO 2008/014853 A1 or U.S. Patent No. 6,980,933. Alternatively, any other implementation known in the art can be applied, and a preferred implementation is discussed in the context of Figs. 10a, 10b.

Specifically, as illustrated in Fig. 10a, the real-to-imaginary converter 1160a comprises a spectral frame selector 1000 connected to an imaginary spectrum calculator 1001. The spectral frame selector 1000 receives an indication of a current frame i at input 1002 and, depending on the implementation, control information at a control input 1003. When, for example, the indication on line 1002 indicates that an imaginary spectrum for a current frame i is to be calculated, and when the control information 1003 indicates that only the current frame is to be used for that calculation, then the spectral frame selector 1000 only selects the current frame i and forwards this information to the imaginary spectrum calculator. Then, the imaginary spectrum calculator only uses the spectral lines of the current frame i to perform a weighted combination of lines positioned in the current frame (block 1008), with respect to frequency, close to or around the current spectral line k, for which an imaginary line is to be calculated as illustrated at 1004 in Fig. 10b. When, however, the spectral frame selector 1000 receives a control information 1003 indicating that the preceding frame i-1 and the following frame i+1 are to be used for the calculation of the imaginary spectrum as well, then the imaginary spectrum calculator additionally receives the values from frames i-1 and i+1 and performs a weighted combination of the lines in the corresponding frames as illustrated at 1005 for frame i-1 and at 1006 for frame i+1. The results of the weighting operations are combined by a weighted combination in block 1007 to finally obtain an imaginary line k for the frame $f_i$ which is then multiplied by the imaginary part of the prediction information in element 1160c to obtain the prediction signal for this line which is then added to the corresponding line of the mid signal in adder 1161b for the decoder. In the encoder, the same operation is performed, but a subtraction in element 2034b is done.

It has to be noted that the control information 1003 can additionally indicate to use more frames than the two surrounding frames or to, for example, only use the current frame and exactly one or more preceding frames but not using "future" frames in order to reduce the systematic delay.

Additionally, it is to be noted that the stage-wise weighted combination illustrated in Fig. 10b, in which, in a first operation, the lines from one frame are combined and, subsequently, the results from these frame-wise combination operations are combined by themselves can also be performed in the other order. The other order means that, in a first step, the lines for the current frequency k from a number of adjacent frames indicated by control information 103 are combined by a weighted combination. This weighted combination is done for the lines k, k-1, k-2, k+1, k+2 etc. depending on the number of adjacent lines to be used for estimating the imaginary line. Then, the results from these "time-wise" combinations are subjected to a weighted combination in the "frequency direction" to finally obtain the imaginary line k for the frame $f_i$. The weights are set to be valued between -1 and 1, preferably, and the weights can be implemented in a straight-forward FIR or IIR filter combination which performs a linear combination of spectral lines or spectral signals from different frequencies and different frames.

As indicated in Figs. 6a and 6b, the preferred transform algorithm is the MDCT transform algorithm which is applied in the forward direction in elements 50 and 51 in Fig. 6a and which is applied in the backward direction in elements 52, 53, subsequent to a combination operation in the combiner 1162 operating in the spectral domain.

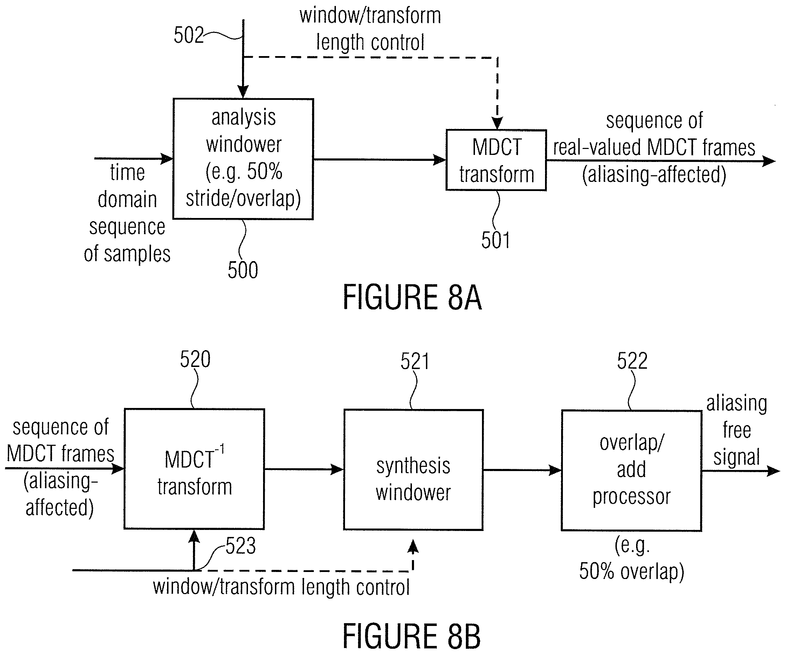

Fig. 8a illustrates a more detailed implementation of block 50 or 51. Particularly, a sequence of time domain audio samples is input into an analysis windower 500 which performs a windowing operation using an analysis window and, particularly, performs this operation in a frame by frame manner, but using a stride or overlap of 50 %. The result of the analysis windower, i.e., a sequence of frames of windowed samples is input into an MDCT transform block 501, which outputs the sequence of real-valued MDCT frames, where these frames are aliasing-affected. Exemplarily, the analysis windower applies analysis windows having a length of 2048 samples. Then, the MDCT transform block 501 outputs MDCT spectra having 1024 real spectral lines or MDCT values. Preferably, the analysis windower 500 and/or the MDCT transformer 501 are controllable by a window length or transform length control 502 so that, for example, for transient portions in the signal, the window length/transform length is reduced in order to obtain better coding results.

Fig. 8b illustrates the inverse MDCT operation performed in blocks 52 and 53. Exemplarily, block 52 comprises a block 520 for performing a frame-by-frame inverse MDCT transform. When, for example, a frame of MDCT values has 1024 values, then the output of this MDCT inverse transform has 2048 aliasing-affected time samples. Such a frame is supplied to a synthesis windower 521, which applies a synthesis window to this frame of 2048 samples. The windowed frame is then forwarded to an overlap/add processor 522 which, exemplarily, applies a 50 % overlap between two subsequent frames and, then, performs a sample by sample addition so that a 2048 samples block finally results in 1024 new samples of the aliasing free output signal. Again, it is preferred to apply a window/transform length control using information which is, for example, transmitted in the side information of the encoded multi-channel signal as indicated at 523.

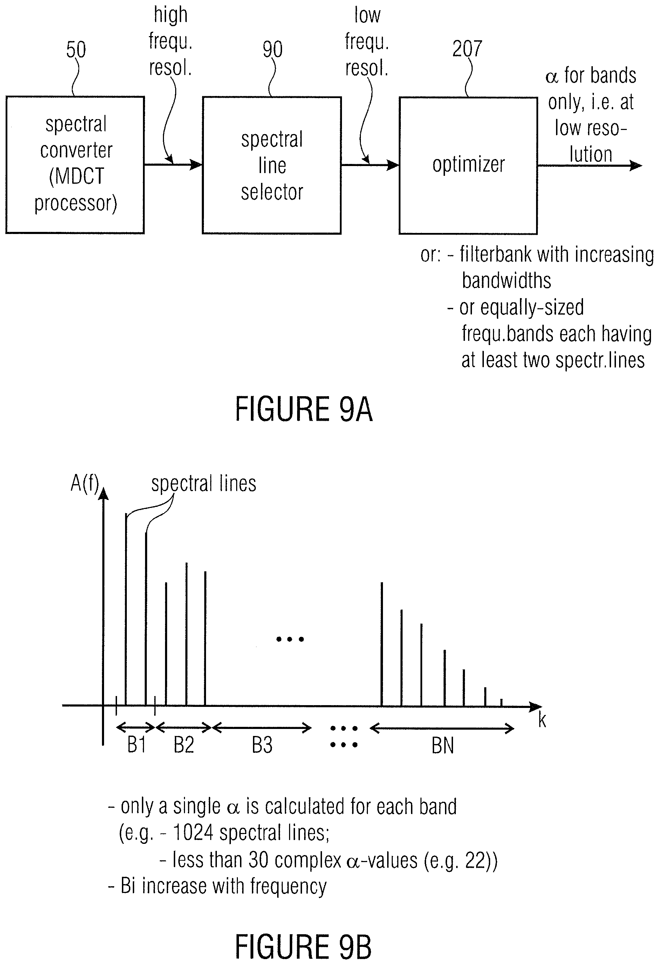

The $\alpha$ prediction values could be calculated for each individual spectral line of an MDCT spectrum. However, it has been found that this is not necessary and a significant amount of side information can be saved by performing a band-wise calculation of the prediction information. Stated differently, a spectral converter 50 illustrated in Fig. 9 which is, for example, an MDCT processor as discussed in the context of Fig. 8a provides a high-frequency resolution spectrum having certain spectral lines illustrated in Fig. 9b. This high frequency resolution spectrum is used by a spectral line selector 90 that provides a low frequency resolution spectrum which comprises certain bands B1, B2, B3, ... , BN. This low frequency resolution spectrum is forwarded to the optimizer 207 for calculating the prediction information so that a prediction information is not calculated for each spectral line, but only for each band. To this end, the optimizer 207 receives the spectral lines per band and calculates the optimization operation starting from the assumption that the same $\alpha$ value is used for all spectral lines in the band.

Preferably, the bands are shaped in a psychoacoustic way so that the bandwidth of the bands increases from lower frequencies to higher frequencies as illustrated in Fig. 9b. Alternatively, although not as preferred as the increasing bandwidth implementation, equally-sized frequency bands could be used as well, where each frequency band has at least two or typically many more, such as at least 30 frequency lines. Typically, for a 1024 spectral lines spectrum, less than 30 complex $\alpha$ values, and preferably, more than 5 $\alpha$ values are calculated. For spectra with less than 1024 spectral lines (e.g. 128 lines), preferably, less frequency bands (e.g. 6) are used for $\alpha$.

For calculating the $\alpha$ values the high resolution MDCT spectrum is not necessarily required. Alternatively, a filter bank having a frequency resolution similar to the resolution required for calculating the $\alpha$ values can be used as well. When bands increasing in frequency are to be implemented, then this filterbank should have varying bandwidth. When, however, a constant bandwidth from low to high frequencies is sufficient, then a traditional filter bank with equiwidth sub-bands can be used.

Depending on the implementation, the sign of the $\alpha$ value indicated in Fig. 3b or 4b can be reversed. To remain consistent, however, it is necessary that this reversion of the sign is used on the encoder side as well as on the decoder side. Compared to Fig. 6a, Fig. 5a illustrates a generalized view of the encoder, where item 2033 is a predictor that is controlled by the predictor control information 206, which is determined in item 207 and which is embedded as side information in the bitstream. Instead of the MDCT used in Fig. 6a in blocks 50, 51, a generalized time/frequency transform is used in Fig. 5a as discussed. As outlined earlier, Fig. 6a is the encoder process which corresponds to the decoder process in Fig. 6b, where L stands for the left channel signal, R stands for the right channel signal, M stands for the mid signal or downmix signal, S stands for the side signal and D stands for the residual signal. Alternatively, L is also called the first channel signal 201, R is also called the second channel signal 202, M is also called the first combination signal 204 and S is also called the second combination signal 2032.

Preferably, the modules 2070 in the encoder and 1160a in the decoder should exactly match in order to ensure correct waveform coding. This applies preferably to the case, in which these modules use some form of approximation such as truncated filters or when it is only made use of one or two instead of the three MDCT frames, i.e. the current MDCT frame on line 60, the preceding MDCT frame on line 61 and the next MDCT frame on line 62.

Additionally, it is preferred that the module 2070 in the encoder in Fig. 6a uses the non-quantized MDCT spectrum M as input, although the real-to-imaginary (R2I) module 1160a in the decoder has only the quantized MDCT spectrum available as input. Alternatively, one can also use an implementation in which the encoder uses the quantized MDCT coefficients as an input into the module 2070. However, using the non-quantized MDCT spectrum as input to the module 2070 is the preferred approach from a perceptual point of view.

Subsequently, several aspects of embodiments of the present invention are discussed in more detail.

Standard parametric stereo coding relies on the capability of the oversampled complex (hybrid) QMF domain to allow for time- and frequency-varying perceptually motivated signal processing without introducing aliasing artifacts. However, in case of downmix/residual coding (as used for the high bit rates considered here), the resulting unified stereo coder acts as a waveform coder. This allows operation in a critically sampled domain, like the MDCT domain, since the waveform coding paradigm ensures that the aliasing cancellation property of the MDCT-IMDCT processing chain is sufficiently well preserved.

However, to be able to exploit the improved coding efficiency that can be achieved in case of stereo signals with inter-channel time- or phase-differences by means of a complex-valued prediction coefficient $\alpha$, a complex-valued frequency-domain representation of the downmix signal DMX is required as input to the complex-valued upmix matrix. This can be obtained by using an MDST transform in addition to the MDCT transform for the DMX signal. The MDST spectrum can be computed (exactly or as an approximation) from the MDCT spectrum.

Furthermore, the parameterization of the upmix matrix can be simplified by transmitting the complex prediction coefficient $\alpha$ instead of MPS parameters. Hence, only two parameters (real and imaginary part of $\alpha$) are transmitted instead of three (ICC, CLD, and IPD). This is possible because of redundancy in the MPS parameterization in case of downmix/residual coding. The MPS parameterization includes information about the relative amount of decorrelation to be added in the decoder (i.e., the energy ratio between the RES and the DMX signals), and this information is redundant when the actual DMX and RES signals are transmitted.

Because of the same reason, the gain factor *g*, shown in the upmix matrix above, is obsolete in case of downmix/residual coding. Hence, the upmix matrix for downmix/residual coding with complex prediction is now:

$$\begin{bmatrix} L \\ R \end{bmatrix} = \begin{bmatrix} 1-\alpha & 1 \\ 1+\alpha & -1 \end{bmatrix} \begin{bmatrix} DMX \\ RES \end{bmatrix}.$$

Compared to Equation 1169 in Fig. 4b, the sign of alpha is inverted in this equation, and DMX=M and RES=D. This is, therefore, an alternative implementation/notation with respect to Fig. 4b.

Two options are available for calculating the prediction residual signal in the encoder. One option is to use the quantized MDCT spectral values of the downmix. This would result in the same quantization error distribution as in M/S coding since encoder and decoder use the same values to generate the prediction. The other option is to use the non-quantized MDCT spectral values. This implies that encoder and decoder will not use the same data for generating the prediction, which allows for spatial redistribution of the coding error according to the instantaneous masking properties of the signal at the cost of a somewhat reduced coding gain.

It is preferable to compute the MDST spectrum directly in the frequency domain by means of two-dimensional FIR filtering of three adjacent MDCT frames as discussed. The latter can be considered as a "real-to-imaginary" (R2I) transform. The complexity of the frequency-domain computation of the MDST can be reduced in different ways, which means that only an approximation of the MDST spectrum is calculated:

- Limiting the number of FIR filter taps.

- Estimating the MDST from the current MDCT frame only.

- Estimating the MDST from the current and previous MDCT frame.

As long as the same approximation is used in the encoder and decoder, the waveform coding properties are not affected. Such approximations of the MDST spectrum, however, can lead to a reduction in the coding gain achieved by complex prediction.

If the underlying MDCT coder supports window-shape switching, the coefficients of the two-dimensional FIR filter used to compute the MDST spectrum have to be adapted to the actual window shapes. The filter coefficients applied to the current frame's MDCT spectrum depend on the complete window, i.e. a set of coefficients is required for every window type and for every window transition. The filter coefficients applied to the previous/next frame's MDCT spectrum depend only on the window half overlapping with the current frame, i.e. for these a set of coefficients is required only for each window type (no additional coefficients for transitions).

If the underlying MDCT coder uses transform-length switching, including the previous and/or next MDCT frame in the approximation becomes more complicated around transitions between the different transforms lengths. Due to the different number of MDCT coefficients in the current and previous/next frame, the two-dimensional filtering is more complicated in this case. To avoid increasing computational and structural complexity, the previous/next frame can be excluded from the filtering at transform-length transitions, at the price of reduced accuracy of the approximation for the respective frames.

Furthermore, special care needs to be taken for the lowest and highest parts of the MDST spectrum (close to DC and fs/2), where less surrounding MDCT coefficients are available for FIR filtering than required. Here the filtering process needs to be adapted to compute the MDST spectrum correctly. This can either be done by using a symmetric extension of the MDCT spectrum for the missing coefficients (according to the periodicity of spectra of time discrete signals), or by adapting filter coefficients accordingly. The handling of these special cases can of course be simplified at the price of a reduced accuracy in vicinity of the borders of the MDST spectrum.

Computing the exact MDST spectrum from the transmitted MDCT spectra in the decoder increases the decoder delay by one frame (here assumed to be 1024 samples).

The additional delay can be avoided by using an approximation of the MDST spectrum that does not require the MDCT spectrum of the next frame as an input.

The following bullet list summarizes the advantages of the MDCT-based unified stereo coding over QMF-based unified stereo coding:

- Only small increase in computational complexity (when SBR is not used).

- Scales up to perfect reconstruction if MDCT spectra are not quantized. Note that this is not the case for QMF-based unified stereo coding.

- Natural extension of M/S coding and intensity stereo coding.

- Cleaner architecture that simplifies encoder tuning, since stereo signal processing and quantization/coding can be tightly coupled. Note that in QMF-based unified stereo coding, MPEG Surround frames and MDCT frames are not aligned and that scalefactor bands don't match parameter bands.

- Efficient coding of stereo parameters, since only two parameters (complex $\alpha$) instead of three parameters as in MPEG Surround (ICC, CLD, IPD) have to be transmitted.

- No additional decoder delay if the MDST spectrum is computed as an approximation (without using the next frame).

Important properties of an implementation can be summarized as follows:

a) MDST spectra are computed by means of two-dimensional FIR filtering from current, previous, and next MDCT spectra. Different complexity/quality trade-offs for the MDST computation (approximation) are possible by reducing the number of FIR filter taps and/or the number of MDCT frames used. In particular, if an adjacent frame is not available because of frame loss during transmission or transform-length switching, that particular frame is excluded from the MDST estimation. For the case of transform-length switching the exclusion is signaled in the bitstream.

b) Only two parameters, the real and imaginary part of the complex prediction coefficient $\alpha$, are transmitted instead of ICC, CLD, and IPD. The real and imaginary parts of $\alpha$ are handled independently, limited to the range [-3.0, 3.0] and quantized with a step size of 0.1. If a certain parameter (real or imaginary part of $\alpha$) is not being used in a given frame, this is signaled in the bitstream, and the irrelevant parameter is not transmitted in accordance with a preferred embodiment of the invention. The parameters are time-differentially or frequency-differentially coded and finally Huffman coding is applied using the scalefactor codebook. The prediction coefficients are updated every second scalefactor band, which results in a frequency resolution similar to that of MPEG Surround. This quantization and coding scheme results in an average bit rate of approximately 2 kb/s for the stereo side information within a typical configuration having a target bit rate of 96 kb/s.

Preferred additional or alternative implementation details comprise:

c) For each of the two parameters of $\alpha$, one may choose non-differential (PCM) or differential (DPCM) coding on a per-frame or per-stream basis, signaled by a corresponding bit in the bit stream. For DPCM coding, either time- or frequency-differential coding is possible. Again, this may be signaled using a one-bit flag.

d) Instead of re-using a pre-defined code book such as the AAC scale factor book, one may also utilize a dedicated invariant or signal-adaptive code book to code the $\alpha$ parameter values, or one may revert to fixed-length (e.g. 4-bit) unsigned or two's-complement code words.

e) The range of $\alpha$ parameter values as well as the parameter quantization step size may be chosen arbitrarily and optimized to the signal characteristics at hand.

f) The number and spectral and/or temporal width of active $\alpha$ parameter bands may be chosen arbitrarily and optimized to the given signal characteristics. In particular, the band configuration may be signaled on a per-frame or per-stream basis.

g) In addition to or instead of the mechanisms outlined in a), above, it may be signaled explicitly by means of a bit per frame in the bitstream that only the MDCT spectrum of the current frame is used to compute the MDST spectrum approximation, i.e., that the adjacent MDCT frames are not taken into account.

Embodiments relate to a system for unified stereo coding in the MDCT-domain. It enables to utilize the advantages of unified stereo coding in the MPEG USAC system even at higher bit rates (where SBR is not used) without the significant increase in computational complexity that would come with a QMF-based approach.

The following two lists summarize preferred configuration aspects described before, which can be used alternatively to each other or in addition to other aspects:

1a) general concept: complex prediction of side MDCT from mid MDCT and MDST;

1b) calculate/approximate MDST from MDCT ("R2I") in frequency domain using 1 or more frames (3-frames introduces delay);

1c) truncation of filter (even down to 1-frame 2-tap, i.e., [-1 0 1]) to reduce computational complexity;

1d) proper handling of DC and fs/2;

1e) proper handling of window shape switching;

1f) do not use previous/next frame if it has a different transform size;

1g) prediction based on non-quantized or quantized MDCT coefficients in the encoder;

2a) quantize and code real and imaginary part of complex prediction coefficient directly (i.e., no MPEG Surround parameterization);

2b) use uniform quantizer for this (step size e.g. 0.1);

2c) use appropriate frequency resolution for prediction coefficients (e.g. 1 coefficient per 2 Scale Factor Bands);

2d) cheap signaling in case all prediction coefficients are real in accordance with a preferred embodiment of the invention;

2e) explicit bit per frame to force 1-frame R2I operation.

In an example, the encoder additionally comprises: a spectral converter (50, 51) for converting a time-domain representation of the two channel signals to a spectral representation of the two channel signals having subband signals for the two channel signals, wherein the combiner (2031), the predictor (2033) and the residual signal calculator (2034) are configured to process each subband signal separately so that the first combined signal and the residual signal are obtained for a plurality of subbands, wherein the output interface (212) is configured for combining the encoded first combined signal and the encoded residual signal for the plurality of subbands.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

In an example, a proper handling of window shape switching is applied. When Fig. 10a is considered, a window shape information 109 can be input into the imaginary spectrum calculator 1001. Specifically, the imaginary spectrum calculator which performs the real-to-imaginary conversion of the real-valued spectrum such as the MDCT spectrum (such as element 2070 in Fig. 6a or element 1160a in Fig. 6b) can be implemented as a FIR or IIR filter. The FIR or IIR coefficients in this real-to-imaginary module 1001 depend on the window shape of the left half and of the right half of the current frame. This window shape can be different for a sine window or a KBD (Kaiser Bessel Derived) window and, subject to the given window sequence configuration, can be a long window, a start window, a stop window, and stop-start window, or a short window. The real-to-imaginary module may comprise a two-dimensional FIR filter, where one dimension is the time dimension where two subsequent MDCT frames are input into the FIR filter, and the second dimension is the frequency dimension, where the frequency coefficients of a frame are input.

The subsequent table gives different MDST filter coefficients for a current window sequence for different window shapes and different implementations of the left half and the right half of the window.

**Table A - MDST Filter Parameters for Current Window**

| Current Window Sequence | Left Half: Sine Shape Right Half: Sine Shape | Left Half: KBD Shape Right Half: KBD Shape |
|---|---|---|
| ONLY_LONG_SEQUENCE, EIGHT_SHORT_SEQUENCE | [0.000000, 0.000000, 0.500000, 0.000000, -0.500000, 0.000000, 0.000000] | [0.091497, 0,000000, 0.581427, 0.000000, -0.581427, 0.000000, -0.091497] |
| LONG_START_SEQUENCE | [0.102658, 0.103791, 0.567149, 0.000000, -0.567149, -0.103791, -0.102658] | [0.150512, 0.047969, 0.608574, 0.000000, -0.608574, -0.047969, -0.150512] |
| LONG_STOP_SEQUENCE | [0.102658, -0.103791, 0.567149, 0.000000, -0.567149, 0.103791, -0.102658] | [0.150512, -0.047969, 0.608574, 0.000000, -0.608574, 0.047969, -0.150512 ] |
| STOP_START_SEQUENCE | [0.205316, 0.000000, 0.634298, 0.000000, -0.634298, 0.000000, -0.205316] | [0.209526, 0.000000, 0.635722, 0.000000, -0.635722, 0.000000, -0.209526] |
| Current Window Sequence | Left Half: Sine Shape Right Half: KBD Shape | Left Half: KBD Shape Right Half: Sine Shape |
| ONLY_LONG_SEQUENCE , EIGHT_SHORT_SEQUENCE | [0.045748, 0.057238, 0.540714, 0.000000, -0.540714, -0.057238, -0.045748] | [0.045748, -0.057238, 0.540714, 0.000000, -0.540714, 0.057238, -0.045748 ] |
| LONG_START_SEQUENCE | [0.104763, 0.105207, 0.567861, 0.000000, -0.567861, -0.105207, -0.104763] | [0.148406, 0.046553, 0.607863, 0.000000, -0.607863, -0.046553, -0.148406] |
| LONG_STOP_SEQUENCE | [0,148406, -0.046553, 0.607863, 0.000000, -0.607863, 0.046553, -0.148406] | [0.104763, -0.105207, 0.567861, 0.000000, -0.567861, 0.105207, -0.104763] |

(continued)

| Current Window Sequence | Left Half: Sine Shape Right Half: KBD Shape | Left Half: KBD Shape Right Half: Sine Shape |
|---|---|---|
| STOP_START_SEQUENCE | [0.207421, 0.001416, 0.635010, 0.000000, -0.635010, -0.001416, -0.207421 ] | [0.207421, -0.001416, 0.635010, 0.000000, -0.635010, 0,001416, -0.207421] |

Additionally, the window shape information 109 provides window shape information for the previous window, when the previous window is used for calculating the MDST spectrum from the MDCT spectrum. Corresponding MDST filter coefficients for the previous window are given in the subsequent table.

**Table B - MDST Filter Parameters for Previous Window**

| Current Window Sequence | Left Half of Current Window: Sine Shape | Left Half of Current Window: KBD Shape |
|---|---|---|
| ONLY_LONG_SEQUENCE, LONG_ START_SEQUENCE, EIGHT_SHORT_ SEQUENCE | [0,000000, 0.106103, 0.250000, 0.318310, 0.250000, 0.106103, 0.000000] | [0.059509. 0.123714, 0.186579, 0.213077, 0.186579, 0.123714, 0.059509] |
| LONG_STOP_SEQUENCE, STOP_ START_SEQUENCE | [0.038498, 0.039212, 0.039645, 0.039790, 0.039645, 0.039212, 0.038498] | [0.026142, 0.026413, 0.026577, 0.026631, 0.026577, 0.026413, 0.026142] |

Hence, depending on the window shape information 109, the imaginary spectrum calculator 1001 in Fig. 10a is adapted by applying different sets of filter coefficients.

The window shape information which is used on the decoder side is calculated on the encoder side and transmitted as side information together with the encoder output signal. On the decoder side, the window shape information 109 is extracted from the bitstream by the bitstream demultiplexer (for example 102 in Fig. 5b) and provided to the imaginary spectrum calculator 1001 as illustrated in Fig. 10a.

When the window shape information 109 signals that the previous frame had a different transform size, then it is preferred that the previous frame is not used for calculating the imaginary spectrum from the real-valued spectrum. The same is true when it is found by interpreting the window shape information 109 that the next frame has a different transform size. Then, the next frame is not used for calculating the imaginary spectrum from the real-valued spectrum. In such a case when, for example, the previous frame had a different transform size from the current frame and when the next frame again has a different transform size compared to the current frame, then only the current frame, i.e. the spectral values of the current window, are used for estimating the imaginary spectrum.

The prediction in the encoder is based on non-quantized or quantized frequency coefficients such as MDCT coefficients. When the prediction illustrated by element 2033 in Fig. 3a, for example, is based on non-quantized data, then the residual calculator 2034 preferably also operates on non-quantized data and the residual calculator output signal, i.e. the residual signal 205 is quantized before being entropy-encoded and transmitted to a decoder. In an alternative implementation, however, it is preferred that the prediction is based on quantized MDCT coefficients. Then, the quantization can take place before the combiner 2031 in Fig. 3a so that a first quantized channel and a second quantized channel are the basis for calculating the residual signal. Alternatively, the quantization can also take place subsequent to the combiner 2031 so that the first combination signal and the second combination signal are calculated in a non-quantized form and are quantized before the residual signal is calculated. Again, alternatively, the predictor 2033 may operate in the non-quantized domain and the prediction signal 2035 is quantized before being input into the residual calculator. Then, it is useful that the second combination signal 2032, which is also input into the residual calculator 2034, is also quantized before the residual calculator calculates the residual signa1070 in Fig. 6a, which may be implemented within the predictor 2033 in Fig. 3a, operates on the same quantized data as are available on the decoder side. Then, it can be guaranteed that the MDST spectrum estimated in the encoder for the purpose of performing the calculation of the residual signal is exactly the same as the MDST spectrum on the decoder side used for performing the inverse prediction, i.e. for calculating the side signal form the residual signal. To this end, the first combination signal such as signal M on line 204 in Fig. 6a is quantized before being input into block 2070. Then, the MDST spectrum calculated using the quantized MDCT spectrum of the current frame, and depending on the control information, the quantized MDCT spectrum of the previous or next frame is input into the multiplier 2074, and the output of multiplier 2074 of Fig. 6a will again be a non-quantized spectrum. This non-quantized spectrum will be subtracted from the spectrum input into adder 2034b and will finally be quantized in quantizer 209b.

In an embodiment, the real part and the imaginary part of the complex prediction coefficient per prediction band are quantized and encoded directly, i.e. without for example MPEG Surround parameterization. The quantization can be performed using a uniform quantizer with a step size, for example, of 0.1. This means that any logarithmic quantization step sizes or the like are not applied, but any linear step sizes are applied. In an implementation, the value range for the real part and the imaginary part of the complex prediction coefficient ranges from -3 to 3, which means that 60 or, depending on implementational details, 61 quantization steps are used for the real part and the imaginary part of the complex prediction coefficient.

Preferably, the real part applied in multiplier 2073 in Fig. 6a and the imaginary part 2074 applied in Fig. 6a are quantized before being applied so that, again, the same value for the prediction is used on the encoder side as is available on the decoder side. This guarantees that the prediction residual signal covers - apart from the introduced quantization error - any errors which might occur when a non-quantized prediction coefficient is applied on the encoder side while a quantized prediction coefficient is applied on the decoder side. Preferably, the quantization is applied in such a way that - as far as possible - the same situation and the same signals are available on the encoder side and on the decoder side. Hence, it is preferred to quantize the input into the real-to-imaginary calculator 2070 using the same quantization as is applied in quantizer 209a. Additionally, it is preferred to quantize the real part and the imaginary part of the prediction coefficient $\alpha$ for performing the multiplications in item 2073 and item 2074. The quantization is the same as is applied in quantizer 2072. Additionally, the side signal output by block 2031 in Fig. 6a can also be quantized before the adders 2034a and 2034b. However, performing the quantization by quantizer 209b subsequent to the addition where the addition by these adders is applied with a non-quantized side signal is not problematic.

In an embodiment of the present invention, a cheap signaling in case all prediction coefficients are real is applied. It can be the situation that all prediction coefficients for a certain frame, i.e. for the same time portion of the audio signal are calculated to be real. Such a situation may occur when the full mid signal and the full side signal are not or only little phase-shifted to each other. In order to save bits, this is indicated by a single real indicator. Then, the imaginary part of the prediction coefficient does not need to be signaled in the bitstream with a codeword representing a zero value. On the decoder side, the bitstream decoder interface, such as a bitstream demultiplexer, will interpret this real indicator and will then not search for codewords for an imaginary part but will assume all bits being in the corresponding section of the bitstream as bits for real-valued prediction coefficients. Furthermore, the predictor 2033, when receiving an indication that all imaginary parts of the prediction coefficients in the frame are zero, will not need to calculate an MDST spectrum, or generally an imaginary spectrum from the real-valued MDCT spectrum. Hence, element 1160a in the Fig. 6b decoder will be deactivated and the inverse prediction will only take place using the real-valued prediction coefficient applied in multiplier 1160b in Fig. 6b. The same is true for the encoder side where element 2070 will be deactivated and prediction will only take place using the multiplier 2073. This side information is preferably used as an additional bit per frame, and the decoder will read this bit frame by frame in order to decide whether the real-to-imaginary converter 1160a will be active for a frame or not. Hence, providing this information results in a reduced size of the bitstream due to the more efficient signaling of all imaginary parts of the prediction coefficient being zero for a frame, and additionally, provides less complexity for the decoder for such a frame which immediately results in a reduced battery consumption of such a processor implemented, for example, in a mobile battery-powered device.

The complex stereo prediction in accordance with preferred embodiments of the present invention is a tool for efficient coding of channel pairs with level and/or phase differences between the channels. Using a complex-valued parameter $\alpha$, the left and right channels are reconstructed via the following matrix. $dmx_{Im}$ denotes the MDST corresponding to the MDCT of the downmix channels $dmx_{Re}$.

$$\begin{bmatrix} r \\ l \end{bmatrix} = \begin{bmatrix} 1-\alpha_{Re} & -\alpha_{Im} & 1 \\ 1+\alpha_{Re} & \alpha_{Im} & -1 \end{bmatrix} \begin{bmatrix} dmx_{Re} \\ dmx_{Im} \\ res \end{bmatrix}$$

The above equation is another representation, which is split with respect to the real part and the imaginary part of $\alpha$ and represents the equation for a combined prediction/combination operation, in which the predicted signal S is not necessarily calculated.

The following data elements are preferably used for this tool:

**cplx_pred_all**     0: Some bands use L/R coding, as signaled by cplx_pred_used[]

1: All bands use complex stereo prediction

(continued)

| | |
|---|---|
| **cplx_pred_used[g][sfb]** | One-bit flag per window group g and scalefactor band sfb (after mapping from prediction bands) indicating that |
| | 0: complex prediction is not being used, L/R coding is used |
| | 1: complex prediction is being used |
| **complex_coef** | 0: $\alpha_{Im}$ = 0 for all prediction bands |
| | 1: $\alpha_{Im}$ is transmitted for all prediction bands |
| **use_prev_frame** | 0: Use only the current frame for MDST estimation |
| | 1: Use current and previous frame for MDST estimation |
| **delta_code_time** | 0: Frequency differential coding of prediction coefficients |
| | 1: Time differential coding of prediction coefficients |
| **hcod_alpha_q_re** | Huffman code of $\alpha_{Re}$ |
| **hcod_alpha_q_im** | Huffman code of $\alpha_{Im}$ |

These data elements are calculated in an encoder and are put into the side information of a stereo or multi-channel audio signal. The elements are extracted from the side information on the decoder side by a side information extractor and are used for controlling the decoder calculator to perform a corresponding action.

Complex stereo prediction requires the downmix MDCT spectrum of the current channel pair and, in case of complex_coef == 1, an estimate of the downmix MDST spectrum of the current channel pair, i.e. the imaginary counterpart of the MDCT spectrum. The downmix MDST estimate is computed from the current frame's MDCT downmix and, in case of use_prev_frame == 1, the previous frame's MDCT downmix. The previous frame's MDCT downmix of window group g and group window b is obtained from that frame's reconstructed left and right spectra.

In the computation of the downmix MDST estimate, the even-valued MDCT transform length is used, which depends on window_sequence, as well as filter_coefs and filter_coefs_prev, which are arrays containing the filter kernels and which are derived according to the previous tables.

For all prediction coefficients the difference to a preceding (in time or frequency) value is coded using a Huffman code book. Prediction coefficients are not transmitted for prediction bands for which cplx_pred_used = 0.

The inverse quantized prediction coefficients alpha_re and alpha_im are given by

$$\text{alpha\_re} = \text{alpha\_q\_re} * 0.1$$

$$\text{alpha\_im} = \text{alpha\_q\_im} * 0.1$$

It is to be emphasized that the invention is not only applicable to stereo signals, i.e. multi-channel signals having only two channels, but is also applicable to two channels of a multi-channel signal having three or more channels such as a 5.1 or 7.1 signal.

Depending on certain implementation requirements, embodiments of the invention can be implemented in hardware or in software. The implementation can be performed using a digital storage medium, for example a floppy disk, a DVD, a CD, a ROM, a PROM, an EPROM, an EEPROM or a FLASH memory, having electronically readable control signals stored thereon, which cooperate (or are capable of cooperating) with a programmable computer system such that the respective method is performed.

Some embodiments according to the invention comprise a non-transitory or tangible data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may for example be stored on a machine readable carrier.

Other embodiments comprise the computer program for performing one of the methods described herein, stored on a machine readable carrier.

In other words, an embodiment of the inventive method is, therefore, a computer program having a program code for performing one of the methods described herein, when the computer program runs on a computer.

A further embodiment of the inventive methods is, therefore, a data carrier (or a digital storage medium, or a computer-readable medium) comprising, recorded thereon, the computer program for performing one of the methods described herein.

A further embodiment of the inventive method is, therefore, a data stream or a sequence of signals representing the computer program for performing one of the methods described herein. The data stream or the sequence of signals may for example be configured to be transferred via a data communication connection, for example via the Internet.

A further embodiment comprises a processing means, for example a computer, or a programmable logic device, configured to or adapted to perform one of the methods described herein.

A further embodiment comprises a computer having installed thereon the computer program for performing one of the methods described herein.

In some embodiments, a programmable logic device (for example a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The above described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

**Claims**

1. Audio decoder for decoding an encoded multi-channel audio signal (100), the encoded multi-channel audio signal comprising an encoded first combination signal generated based on a combination rule for combining a first channel audio signal and a second channel audio signal of a multi-channel audio signal, an encoded prediction residual signal and prediction information, comprising:

    a signal decoder (110) for decoding the encoded first combination signal (104) to obtain a decoded first combination signal (112), and for decoding the encoded residual signal (106) to obtain a decoded residual signal (114); and
    a decoder calculator (116) for calculating a decoded multi-channel signal having a decoded first channel signal (117), and a decoded second channel signal (118) using the decoded residual signal (114), the prediction information (108) and the decoded first combination signal (112), so that the decoded first channel signal (117) and the decoded second channel signal (118) are at least approximations of the first channel signal and the second channel signal of the multi-channel signal, wherein the prediction information (108) comprises prediction coefficients for frames, a prediction coefficient having a real-valued factor different from zero and an imaginary factor different from zero,
    wherein the decoder calculator (116) comprises:

    a predictor (1160) for applying the prediction information (108) to the decoded first combination signal (112) or to a signal (601) derived from the decoded first combination signal to obtain a prediction signal (1163);
    a combination signal calculator (1161) for calculating a second combination signal (1165) by combining the decoded residual signal (114) and the prediction signal (1163);
    wherein the predictor (1160) is configured for multiplying (1160b) the decoded first combination signal by the real-valued factor of a prediction coefficient to obtain a first part of the prediction signal,
    wherein the predictor (1160) is configured for estimating (1160a) an imaginary part (601) of the decoded first combination signal (112) using a real part of the decoded first combination signal (112),
    wherein the predictor (1160) is configured for multiplying (1161c) the imaginary part (601) of the decoded first combination signal by the imaginary factor of the prediction coefficient to obtain a second part of the prediction signal;

wherein the combination signal calculator (1161) is configured for linearly combining (1161a, 1161b) the first part of the prediction signal and the second part of the prediction signal and the decoded residual signal to obtain a second combination signal (1165); and

a combiner (1162) for combining the decoded first combination signal (112) and the second combination signal (1165) to obtain the decoded multi-channel audio signal having the decoded first channel signal (117) and the decoded second channel signal (118),

wherein the encoded multi-channel signal comprises, as side information, a real indicator indicating, in a first state, that all prediction coefficients for a certain frame of the encoded multi-channel signal are real valued and do not have an imaginary portion different from zero, and indicating in a second state that prediction coefficients for a frame comprise an imaginary portion different from zero,

wherein the audio decoder is configured for extracting the real indicator from the encoded multi-channel audio signal (100) for the certain frame, and

wherein the decoder calculator (116) is configured for not calculating the imaginary part (601) of the decoded first combination signal (112) for the certain frame, for which the real indicator has the first state indicating only real-valued prediction coefficients for the certain frame.

2. Audio decoder in accordance with claim 1,
in which the encoded first combination signal (104) and the encoded residual signal (106) have been generated using an aliasing generating time-spectral conversion, wherein the decoder further comprises:

a spectral-time converter (52, 53) for generating a time-domain first channel signal and a time-domain second channel signal using a spectral-time conversion algorithm matched to the time-spectral conversion algorithm;
an overlap/add processor (522) for conducting an overlap-add processing for the time-domain first channel signal and for the time-domain second channel signal to obtain an aliasing-free first time-domain signal and an aliasing-free second time-domain signal.

3. Audio decoder in accordance with one of the preceding claims,
in which the encoded or decoded first combination signal (104) and the encoded or decoded prediction residual signal (106) each comprises a first plurality of subband signals,
wherein the prediction information comprises a second plurality of prediction information coefficients, the second plurality being smaller than the first plurality,
wherein the predictor (1160) is configured for applying the same prediction coefficient to at least two different subband signals of the decoded first combination signal,
wherein the decoder calculator (116) or the combination signal calculator (1161) or the combiner (1162) are configured for performing a subband-wise processing; and
wherein the audio decoder further comprises a synthesis filterbank (52, 53) for combining subband signals of the decoded first channel signal (117) and the decoded second channel signal (118) to obtain a time-domain decoded first channel signal and a time-domain decoded second channel signal.

4. Audio decoder in accordance with claim 1,
wherein the encoded multi-channel audio signal does not comprise codewords representing a zero value for imaginary parts of prediction coefficients for the certain frame having the real indicator indicating the first state, and
wherein a bitstream decoder interface is configured to interpret the real indicator so that the bitstream decoder interface does not search for the codewords for imaginary parts of prediction coefficients for the certain frame and assumes that all bits being in a corresponding section of a bitstream representing the encoded multichannel signal are bits for the real-valued prediction coefficients for the certain frame.

5. Audio decoder in accordance with claim 1, being configured to deactivate an element performing the estimating (1160a) the imaginary part (601) of the decoded first combination signal (112) for the certain frame having the real indicator indicating the first state, and
wherein the combination signal calculator (1161) is configured for linearly combining only the first part of the prediction signal obtained by the multiplying (1160b) the decoded first combination signal by the real-valued factor of a prediction coefficient and the decoded residual signal to obtain the second combination signal (1165).

6. Audio decoder in accordance with claim 1, wherein the real indicator is implemented by an additional bit per frame, and wherein the decoder is configured for reading the additional bit frame by frame to decide, whether the estimating (1160a) the imaginary part (601) of the decoded first combination signal (112) for the certain frame is active or not for a frame.

7. Audio encoder for encoding a multi-channel audio signal having two or more channel signals, comprising:

an encoder calculator (203) for calculating a first combination signal (204) and a prediction residual signal (205) using a first channel signal (201) and a second channel signal (202) and prediction information (206) comprising prediction coefficients for frames, so that a prediction residual signal, when combined with a prediction signal derived from the first combination signal or a signal derived from the first combination signal and the prediction information (206) results in a second combination signal (2032), the first combination signal (204) and the second combination signal (2032) being derivable from the first channel signal (201) and the second channel signal (202) using a combination rule;
an optimizer (207) for calculating the prediction information (206) comprising the prediction coefficients for the frames, so that the prediction residual signal (205) fulfills an optimization target (208);
wherein the encoder calculator (203) comprises:

a combiner (2031) for combining the first channel signal (201) and the second channel signal (202) in two different ways to obtain the first combination signal (204) and the second combination signal (2032);
a predictor (2033) for applying the prediction information (206) to the first combination signal (204) or a signal (600) derived from the first combination signal (204) to obtain a prediction signal (2035); and
a residual signal calculator (2034) for calculating the prediction residual signal (205) by combining the prediction signal (2035) and the second combination signal (2032),

wherein the predictor (2033) is configured for

multiplying (2073) the first combination signal (204) by a real part of the prediction information to obtain a first part of the prediction signal;
estimating (2070) an imaginary part (600) of the first combination signal using the first combination signal (204);
multiplying (2074) the imaginary part of the first combination signal by an imaginary part of the prediction information to obtain a second part of the prediction signal; and

wherein the residual calculator (2034) is configured for linearly combining (2034a, 2034b) the first part of the prediction signal and the second part of the prediction signal and the second combination signal to obtain the prediction residual signal (205);
a signal encoder (209) for encoding the first combination signal (204) and the prediction residual signal (205) to obtain an encoded first combination signal (210) and an encoded residual signal (211); and
an output interface (212) for combining the encoded first combination signal (210), the encoded prediction residual signal (211), the prediction information (206), and a real indicator indicating a situation that all prediction coefficients for a certain frame are real coefficients to obtain an encoded multi-channel audio signal, and wherein the encoded multi-channel audio signal does not comprise codewords representing a zero value for imaginary parts of prediction coefficients for the certain frame having the real indicator.

8. Audio encoder in accordance with claim 7, in which the predictor (2033) comprises a quantizer for quantizing the first channel signal, the second channel signal, the first combination signal or the second combination signal to obtain one or more quantized signals, and wherein the predictor (2033) is configured for calculating the residual signal using the quantized signals.

9. Audio encoder in accordance with one of claims 7 to 8,
in which the first channel signal is a spectral representation of a block of samples;
in which the second channel signal is a spectral representation of a block of samples,
wherein the spectral representations are pure real spectral representations,
in which the optimizer (207) is configured for calculating the prediction information (206) as a real-valued factor different from zero and as an imaginary factor different from zero, and
in which the encoder calculator (203) is configured to calculate the first combination signal and the prediction residual signal so that the prediction signal is derived from the pure real spectral representation using the real-valued factor.

**10.** Audio encoder in accordance with one of claims 7 to 9,
in which the first channel signal is a spectral representation of a block of samples;
in which the second channel signal is a spectral representation of a block of samples,
wherein the spectral representations are pure real spectral representations,
in which the optimizer (207) is configured for calculating the prediction information (206) as a real-valued factor different from zero and as an imaginary factor different from zero, and
in which the encoder calculator (203) comprises the real-to-imaginary transformer (2070) for the estimating (2070) the imaginary part (600) of the first combination signal.

**11.** Audio encoder in accordance with claim 7, being configured to deactivate an element performing the estimating (2070) the imaginary part (600) of the first combination signal (204) for the certain frame having the real indicator, and wherein the residual calculator (2034) is configured for linearly combining (2034) only the first part of the prediction signal obtained by the multiplying (2073) the first combination signal by the real-valued portion of a prediction coefficient and the second combination signal to obtain the residual signal.

**12.** Audio encoder in accordance with claim 7, wherein the real indicator is implemented by an additional bit per frame, and wherein the audio encoder is configured for putting the additional bit frame by frame into side information to indicate, whether the estimating (2017) the imaginary part (600) of the first combination signal (112) is active or not for a frame.

**13.** Audio encoder in accordance with claim 7, wherein the real indicator is a data element associated with each frame indicating in a first state that all prediction coefficients for a frame are real-valued only and indicating in a second state that imaginary parts for prediction coefficients are transmitted for all prediction bands.

**14.** Method of decoding an encoded multi-channel audio signal (100), the encoded multi-channel audio signal comprising an encoded first combination signal generated based on a combination rule for combining a first channel audio signal and a second channel audio signal of a multi-channel audio signal, an encoded prediction residual signal and prediction information, comprising:

decoding (110) the encoded first combination signal (104) to obtain a decoded first combination signal (112), and decoding the encoded residual signal (106) to obtain a decoded residual signal (114); and
calculating (116) a decoded multi-channel signal having a decoded first channel signal (117), and a decoded second channel signal (118) using the decoded residual signal (114), the prediction information (108) and the decoded first combination signal (112), so that the decoded first channel signal (117) and the decoded second channel signal (118) are at least approximations of the first channel signal and the second channel signal of the multi-channel signal, wherein the prediction information (108) comprises prediction coefficients for frames, a prediction coefficient having a real-valued factor different from zero and an imaginary factor different from zero, wherein the calculating (116) comprises:

applying (1160) the prediction information (108) to the decoded first combination signal (112) or to a signal (601) derived from the decoded first combination signal to obtain a prediction signal (1163);
calculating (1161) a second combination signal (1165) by combining the decoded residual signal (114) and the prediction signal (1163);
wherein the applying (1160) comprises multiplying (1160b) the decoded first combination signal by the real-valued factor of a prediction coefficient to obtain a first part of the prediction signal,
wherein the applying (1160) comprises estimating (1160a) an imaginary part (601) of the decoded first combination signal (112) using a real part of the decoded first combination signal (112),
wherein the applying (1160) comprises multiplying (1161c) the imaginary part (601) of the decoded first combination signal by the imaginary factor of the prediction coefficient to obtain a second part of the prediction signal;
wherein the calculating (1161) comprises linearly combining (1161a, 1161b) the first part of the prediction signal and the second part of the prediction signal and the decoded residual signal to obtain a second combination signal (1165); and
combining (1162) the decoded first combination signal (112) and the second combination signal (1165) to obtain the decoded multi-channel audio signal having the decoded first channel signal (117) and the decoded second channel signal (118),

wherein the encoded multi-channel signal comprises, as side information, a real indicator indicating, in a first state, that all prediction coefficients for a certain frame of the encoded multi-channel signal are real valued and do not have an imaginary portion different from zero, and indicating in a second state that prediction coefficients for a frame comprise an imaginary portion different from zero,

wherein the method further comprises extracting the real indicator from the encoded multi-channel audio signal (100) for the certain frame, and

wherein the imaginary part (601) of the decoded first combination signal (112) is not calculated for the certain frame, for which the real indicator has the first state indicating only real-valued prediction coefficients for the certain frame.

**15.** Method of encoding a multi-channel audio signal having two or more channel signals, comprising:

calculating (203) a first combination signal (204) and a prediction residual signal (205) using a first channel signal (201) and a second channel signal (202) and prediction information (206) comprising prediction coefficients for frames, so that a prediction residual signal, when combined with a prediction signal derived from the first combination signal or a signal derived from the first combination signal and the prediction information (206) results in a second combination signal (2032), the first combination signal (204) and the second combination signal (2032) being derivable from the first channel signal (201) and the second channel signal (202) using a combination rule;

calculating (207) the prediction information (206) comprising the prediction coefficients for the frames, so that the prediction residual signal (205) fulfills an optimization target (208));

wherein the calculating (203) the first combination signal (204) and the prediction residual signal (205) comprises:

combining (2031) the first channel signal (201) and the second channel signal (202) in two different ways to obtain the first combination signal (204) and the second combination signal (2032);

applying (2033) the prediction information (206) to the first combination signal (204) or a signal (600) derived from the first combination signal (204) to obtain a prediction signal (2035); and

calculating (2034) the prediction residual signal (205) by combining the prediction signal (2035) and the second combination signal (2032),

wherein the applying (2033) comprises

multiplying (2073) the first combination signal (204) by a real part of the prediction information to obtain a first part of the prediction signal; estimating (2070) an imaginary part (600) of the first combination signal using the first combination signal (204);

multiplying (2074) the imaginary part of the first combination signal by an imaginary part of the prediction information to obtain a second part of the prediction signal; and

wherein the calculating (2034) the prediction residual signal (205) comprises linearly combining (2034a, 2034b) the first part of the prediction signal and the second part of the prediction signal and the second combination signal to obtain the prediction residual signal (205);

encoding (209) the first combination signal (204) and the prediction residual signal (205) to obtain an encoded first combination signal (210) and an encoded residual signal (211); and

combining (212) the encoded first combination signal (210), the encoded prediction residual signal (211), the prediction information (206) and a real indicator indicating a situation that all prediction coefficients for a certain frame are real coefficients to obtain an encoded multi-channel audio signal.

**16.** Computer program adapted to perform, when running on a computer or a processor, the method of claim 14 or the method of claim 15.

**Patentansprüche**

**1.** Audiodecodierer zum Decodieren eines codierten Mehrkanalaudiosignals (100), wobei das codierte Mehrkanalaudiosignal ein codiertes erstes Kombinationssignal, das basierend auf einer Kombinationsregel zum Kombinieren eines Erster-Kanal-Audiosignals und eines Zweiter-Kanal-Audiosignals eines Mehrkanalaudiosignals erzeugt wird, ein codiertes Prädiktionsrestsignal und Prädiktionsinformationen aufweist, der folgende Merkmale aufweist:

einen Signaldecodierer (110) zum Decodieren des codierten ersten Kombinationssignals (104), um ein decodiertes erstes Kombinationssignal (112) zu erhalten, und zum Decodieren des codierten Restsignals (106), um ein decodiertes Restsignal (114) zu erhalten; und

eine Decodiererberechnungseinrichtung (116) zum Berechnen eines decodierten Mehrkanalsignals, das ein decodiertes Erster-Kanal-Signal (117) und ein decodiertes Zweiter-Kanal-Signal (118) aufweist, unter Verwendung des decodierten Restsignals (114), der Prädiktionsinformationen (108) und des decodierten ersten Kombinationssignals (112), so dass das decodierte Erster-Kanal-Signal (117) und das decodierte Zweiter-Kanal-Signal (118) zumindest Näherungen des Erster-Kanal-Signals und des Zweiter-Kanal-Signals des Mehrkanalsignals sind, wobei die Prädiktionsinformationen (108) Prädiktionskoeffizienten für Rahmen aufweisen, wobei ein Prädiktionskoeffizient einen reellwertigen Faktor, der sich von null unterscheidet, und einen Imaginärfaktor, der sich von null unterscheidet, aufweist,

wobei die Decodiererberechnungseinrichtung (116) folgende Merkmale aufweist:

einen Prädiktor (1160) zum Anlegen der Prädiktionsinformationen (108) an das decodierte erste Kombinationssignal (112) oder an ein Signal (601), das von dem decodierten ersten Kombinationssignal abgeleitet ist, um ein Prädiktionssignal (1163) zu erhalten;

eine Kombinationssignalberechnungseinrichtung (1161) zum Berechnen eines zweiten Kombinationssignals (1165) durch Kombinieren des decodierten Restsignals (114) und des Prädiktionssignals (1163);

wobei der Prädiktor (1160) dazu konfiguriert ist, das decodierte erste Kombinationssignal mit dem reellwertigen Faktor eines Prädiktionskoeffizienten zu multiplizieren (1160b), um einen ersten Teil des Prädiktionssignals zu erhalten,

wobei der Prädiktor (1160) dazu konfiguriert ist, einen Imaginärteil (601) des decodierten ersten Kombinationssignals (112) unter Verwendung eines Realteils des decodierten ersten Kombinationssignals (112) zu schätzen (1160a),

wobei der Prädiktor (1160) dazu konfiguriert ist, den Imaginärteil (601) des decodierten ersten Kombinationssignals mit dem Imaginärfaktor des Prädiktionskoeffizienten zu multiplizieren (1161c), um einen zweiten Teil des Prädiktionssignals zu erhalten,

wobei die Kombinationssignalberechnungseinrichtung (1161) dazu konfiguriert ist, den ersten Teil des Prädiktionssignals und den zweiten Teil des Prädiktionssignals und das decodierte Restsignal linear zu kombinieren (1161a, 1161b), um ein zweites Kombinationssignal (1165) zu erhalten; und

einen Kombinierer (1162) zum Kombinieren des decodierten ersten Kombinationssignals (112) und des zweiten Kombinationssignals (1165), um das decodierte Mehrkanalaudiosignal zu erhalten, das das decodierte Erster-Kanal-Signal (117) und das decodierte Zweiter-Kanal-Signal (118) aufweist,

wobei das codierte Mehrkanalsignal als Nebeninformationen einen reellen Indikator aufweist, der in einem ersten Zustand angibt, dass alle Prädiktionskoeffizienten für einen gewissen Rahmen des codierten Mehrkanalsignals reellwertig sind und keinen Imaginärabschnitt aufweisen, der sich von null unterscheidet, und der in einem zweiten Zustand angibt, dass Prädiktionskoeffizienten für einen Rahmen einen Imaginärabschnitt aufweisen, der sich von null unterscheidet,

wobei der Audiodecodierer dazu konfiguriert ist, den reellen Indikator aus dem codierten Mehrkanalaudiosignal (100) für den gewissen Rahmen zu extrahieren, und

wobei die Decodiererberechnungseinrichtung (116) dazu konfiguriert ist, den Imaginärteil (601) des decodierten ersten Kombinationssignals (112) für den gewissen Rahmen, für den der reelle Indikator den ersten Zustand aufweist, der lediglich reellwertige Prädiktionskoeffizienten für den gewissen Rahmen angibt, nicht zu berechnen.

2.  Audiodecodierer gemäß Anspruch 1,
    bei dem das codierte erste Kombinationssignal (104) und das codierte Restsignal (106) unter Verwendung einer Aliasing-erzeugenden Zeit-Spektral-Umwandlung erzeugt wurden,
    wobei der Decodierer ferner folgende Merkmale aufweist:

    einen Spektral-Zeit-Wandler (52, 53) zum Erzeugen eines Zeitbereich-Erster-Kanal-Signals und eines Zeitbereich-Zweiter-Kanal-Signals unter Verwendung eines Spektral-Zeit-Umwandlungsalgorithmus, der auf den Zeit-Spektral-Umwandlungsalgorithmus abgestimmt ist;
    einen Überlappen/Addieren-Prozessor (522) zum Durchführen einer Überlappen/Addieren-Verarbeitung für das Zeitbereich-Erster-Kanal-Signal und für das Zeitbereich-Zweiter-Kanal-Signal, um ein Aliasing-freies erstes Zeitbereichssignal und ein Aliasing-freies zweites Zeitbereichssignal zu erhalten.

3.  Audiodecodierer gemäß einem der vorhergehenden Ansprüche,

bei dem das codierte oder decodierte erste Kombinationssignal (104) und das codierte oder decodierte Prädiktionsrestsignal (106) jeweils eine erste Mehrzahl von Teilbandsignalen aufweisen,

bei dem die Prädiktionsinformationen eine zweite Mehrzahl von Prädiktionsinformationskoeffizienten aufweisen, wobei die zweite Mehrzahl kleiner ist als die erste Mehrzahl,

bei dem der Prädiktor (1160) konfiguriert ist zum Anlegen des gleichen Prädiktionskoeffizienten an zumindest zwei unterschiedliche Teilbandsignale des decodierten ersten Kombinationssignals,

bei dem die Decodiererberechnungseinrichtung (116) oder die Kombinationssignalberechnungseinrichtung (1161) oder der Kombinierer (1162) konfiguriert sind zum Durchführen einer teilbandweisen Verarbeitung; und

wobei der Audiodecodierer ferner eine Synthesefilterbank (52, 53) aufweist zum Kombinieren von Teilbandsignalen des decodierten Erster-Kanal-Signals (117) und des decodierten Zweiter-Kanal-Signals (118), um ein decodiertes Zeitbereich-Erster-Kanal-Signal und ein decodiertes Zeitbereich-Zweiter-Kanal-Signal zu erhalten.

4. Audiodecodierer gemäß Anspruch 1,

bei dem das codierte Mehrkanalaudiosignal keine einen Nullwert darstellende Codewörter für Imaginärteile von Prädiktionskoeffizienten für den gewissen Rahmen aufweist, der den reellen Indikator aufweist, der den ersten Zustand angibt, und

bei dem eine Bitstromdecodiererschnittstelle dazu konfiguriert ist, den reellen Indikator so zu interpretieren, dass die Bitstromdecodiererschnittstelle nicht nach den Codewörtern für Imaginärteile von Prädiktionskoeffizienten für den gewissen Rahmen sucht und annimmt, dass alle Bits, die sich in einem entsprechenden Segment eines Bitstroms befinden, der das codierte Mehrkanalsignal darstellt, Bits für die reellwertigen Prädiktionskoeffizienten für den gewissen Rahmen sind.

5. Audiodecodierer gemäß Anspruch 1, der dazu konfiguriert ist, ein Element zu deaktivieren, das das Schätzen (1160a) des Imaginärteils (601) des decodierten ersten Kombinationssignals (112) für den gewissen Rahmen durchführt, der den den ersten Zustand angebenden reellen Indikator aufweist, und

bei dem die Kombinationssignalberechnungseinrichtung (1161) dazu konfiguriert ist, lediglich den ersten Teil des Prädiktionssignals, der durch das Multiplizieren (1160b) des decodierten ersten Kombinationssignals mit dem reellwertigen Faktor eines Prädiktionskoeffizienten erhalten wurde, und das decodierte Restsignal linear zu kombinieren, um das zweite Kombinationssignal (1165) zu erhalten.

6. Audiodecodierer gemäß Anspruch 1, bei dem der reelle Indikator durch ein zusätzliches Bit pro Rahmen implementiert ist und wobei der Decodierer dazu konfiguriert ist, das zusätzliche Bit rahmenweise zu lesen, um zu entscheiden, ob das Schätzen (1160a) des Imaginärteils (601) des decodierten ersten Kombinationssignals (112) für den gewissen Rahmen für einen Rahmen aktiv ist oder nicht.

7. Audiocodierer zum Codieren eines Mehrkanalaudiosignals, das Zwei- oder MehrKanal-Signale aufweist, wobei der Audiocodierer folgende Merkmale aufweist:

eine Codiererberechnungseinrichtung (203) zum Berechnen eines ersten Kombinationssignals (204) und eines Prädiktionsrestsignals (205) unter Verwendung eines Erster-Kanal-Signals (201) und eines Zweiter-Kanal-Signals (202) und von Prädiktionsinformationen (206), die Prädiktionskoeffizienten für Rahmen aufweisen, so dass ein Prädiktionsrestsignal, wenn es mit einem von dem ersten Kombinationssignal abgeleiteten Prädiktionssignal oder mit einem Signal, das von dem ersten Kombinationssignal und den Prädiktionsinformationen (206) abgeleitet ist, kombiniert wird, zu einem zweiten Kombinationssignal (2032) führt, wobei das erste Kombinationssignal (204) und das zweite Kombinationssignal (2032) unter Verwendung einer Kombinationsregel von dem Erster-Kanal-Signal (201) und dem Zweiter-Kanal-Signal (202) ableitbar sind;

einen Optimierer (207) zum Berechnen der Prädiktionsinformationen (206), die die Prädiktionskoeffizienten für die Rahmen aufweisen, so dass das Prädiktionsrestsignal (205) ein Optimierungsziel (208) erfüllt;

wobei die Codiererberechnungseinrichtung (203) folgende Merkmale aufweist:

einen Kombinierer (2031) zum Kombinieren des Erster-Kanal-Signals (201) und des Zweiter-Kanal-Signals (202) auf zwei unterschiedliche Weisen, um das erste Kombinationssignal (204) und das zweite Kombinationssignal (2032) zu erhalten;

einen Prädiktor (2033) zum Anlegen der Prädiktionsinformationen (206) an das erste Kombinationssignal (204) oder ein Signal (600), das von dem ersten Kombinationssignal (204) abgeleitet ist, um ein Prädiktionssignal (2035) zu erhalten; und

eine Restsignalberechnungseinrichtung (2034) zum Berechnen des Prädiktionsrestsignals (205) durch Kombinieren des Prädiktionssignals (2035) und des zweiten Kombinationssignals (2032),

wobei der Prädiktor (2033) dazu konfiguriert ist,

das erste Kombinationssignal (204) mit einem Realteil der Prädiktionsinformationen zu multiplizieren (2073), um einen ersten Teil des Prädiktionssignals zu erhalten;
einen Imaginärteil (600) des ersten Kombinationssignals unter Verwendung des ersten Kombinationssignals (204) zu schätzen (2070);
den Imaginärteil des ersten Kombinationssignals mit einem Imaginärteil der Prädiktionsinformationen zu multiplizieren (2074), um einen zweiten Teil des Prädiktionssignals zu erhalten; und

wobei die Restberechnungseinrichtung (2034) dazu konfiguriert ist, den ersten Teil des Prädiktionssignals und den zweiten Teil des Prädiktionssignals und das zweite Kombinationssignal linear zu kombinieren (2034a, 2034b), um das Prädiktionsrestsignal (205) zu erhalten;
einen Signalcodierer (209) zum Codieren des ersten Kombinationssignals (204) und des Prädiktionsrestsignals (205), um ein codiertes erstes Kombinationssignal (210) und codiertes Restsignal (211) zu erhalten; und
eine Ausgangsschnittstelle (212) zum Kombinieren des codierten ersten Kombinationssignals (210), des codierten Prädiktionsrestsignals (211), der Prädiktionsinformation (206) und eines reellen Indikators, der eine Situation angibt, in der alle Prädiktionskoeffizienten für einen gewissen Rahmen reelle Koeffizienten sind, um ein codiertes Mehrkanalaudiosignal zu erhalten, und wobei das codierte Mehrkanalaudiosignal keine einen Nullwert darstellende Codewörter für Imaginärteile von Prädiktionskoeffizienten für den gewissen Rahmen aufweist, der den reellen Indikator aufweist.

8. Audiocodierer gemäß Anspruch 7, bei dem der Prädiktor (2033) einen Quantisierer zum Quantisieren des Erster-Kanal-Signals, des Zweiter-Kanal-Signals, des ersten Kombinationssignals oder des zweiten Kombinationssignals aufweist, um ein oder mehrere quantisierte Signale zu erhalten, und bei dem der Prädiktor (2033) zum Berechnen des Restsignals unter Verwendung der quantisierten Signale konfiguriert ist.

9. Audiocodierer gemäß einem der Ansprüche 7 bis 8,
bei dem das Erster-Kanal-Signal eine Spektraldarstellung eines Blocks von Abtastwerten ist;
bei dem das Zweiter-Kanal-Signal eine Spektraldarstellung eines Blocks von Abtastwerten ist,
wobei die Spektraldarstellungen reine reelle Spektraldarstellungen sind,
bei dem der Optimierer (207) dazu konfiguriert ist, die Prädiktionsinformationen (206) als reellwertigen Faktor, der sich von null unterscheidet, und als Imaginärfaktor, der sich von null unterscheidet, zu berechnen, und
bei dem die Codiererberechnungseinrichtung (203) dazu konfiguriert ist, das erste Kombinationssignal und das Prädiktionsrestsignal zu berechnen, so dass das Prädiktionssignal unter Verwendung des reellwertigen Faktors von der reinen reellen Spektraldarstellung abgeleitet wird.

10. Audiocodierer gemäß einem der Ansprüche 7 bis 9,
bei dem das Erster-Kanal-Signal eine Spektraldarstellung eines Blocks von Abtastwerten ist;
bei dem das Zweiter-Kanal-Signal eine Spektraldarstellung eines Blocks von Abtastwerten ist,
wobei die Spektraldarstellungen reine reelle Spektraldarstellungen sind,
bei dem der Optimierer (207) dazu konfiguriert ist, die Prädiktionsinformationen (206) als reellwertigen Faktor, der sich von null unterscheidet, und als Imaginärfaktor, der sich von null unterscheidet, zu berechnen, und
bei dem die Codiererberechnungseinrichtung (203) den Real-Zu-Imaginär-Transformierer (2070) zum Schätzen (2070) des Imaginärteils (600) des ersten Kombinationssignals aufweist.

11. Audiocodierer gemäß Anspruch 7, der dazu konfiguriert ist, ein Element zu deaktivieren, das das Schätzen (2070) des Imaginärteils (600) des ersten Kombinationssignals (204) für den gewissen Rahmen durchführt, der den reellen Indikator aufweist, und
bei dem die Restberechnungseinrichtung (2034) dazu konfiguriert ist, lediglich den ersten Teil des Prädiktionssignals, der durch das Multiplizieren (2073) des ersten Kombinationssignals mit dem reellwertigen Abschnitt eines Prädiktionskoeffizienten erhalten wurde, und das zweite Kombinationssignal linear zu kombinieren (2034), um das Restsignal zu erhalten.

12. Audiocodierer gemäß Anspruch 7, bei dem der reelle Indikator durch ein zusätzliches Bit pro Rahmen implementiert ist und wobei der Audiocodierer dazu konfiguriert ist, das zusätzliche Bit rahmenweise in Nebeninformationen einzugeben, um anzugeben, ob das Schätzen (2017) des Imaginärteils (600) des ersten Kombinationssignals (112) für einen Rahmen aktiv ist oder nicht.

**13.** Audiocodierer gemäß Anspruch 7, bei dem der reelle Indikator ein jedem Rahmen zugeordnetes Datenelement ist, das in einem ersten Zustand angibt, dass alle Prädiktionskoeffizienten für einen Rahmen lediglich reellwertig sind, und das in einem zweiten Zustand angibt, dass Imaginärteile für Prädiktionskoeffizienten für alle Prädiktionsbänder übertragen werden.

**14.** Verfahren zum Decodieren eines codierten Mehrkanalaudiosignals (100), wobei das codierte Mehrkanalaudiosignal ein codiertes erstes Kombinationssignal, das basierend auf einer Kombinationsregel zum Kombinieren eines Erster-Kanal-Audiosignals und eines Zweiter-Kanal-Audiosignals eines Mehrkanalaudiosignals erzeugt wird, ein codiertes Prädiktionsrestsignal und Prädiktionsinformationen aufweist, wobei das Verfahren folgende Schritte aufweist:

Decodieren (110) des codierten ersten Kombinationssignals (104), um ein decodiertes erstes Kombinationssignal (112) zu erhalten, und Decodieren des codierten Restsignals (106), um ein decodiertes Restsignal (114) zu erhalten; und

Berechnen (116) eines decodierten Mehrkanalsignals, das ein decodiertes Erster-Kanal-Signal (117) und ein decodiertes Zweiter-Kanal-Signal (118) aufweist, unter Verwendung des decodierten Restsignals (114), der Prädiktionsinformationen (108) und des decodierten ersten Kombinationssignals (112), so dass das decodierte Erster-Kanal-Signal (117) und das decodierte Zweiter-Kanal-Signal (118) zumindest Näherungen des Erster-Kanal-Signals und des Zweiter-Kanal-Signals des Mehrkanalsignals sind, wobei die Prädiktionsinformationen (108) Prädiktionskoeffizienten für Rahmen aufweisen, wobei ein Prädiktionskoeffizient einen reellwertigen Faktor, der sich von null unterscheidet, und einen Imaginärfaktor, der sich von null unterscheidet, aufweist, wobei das Berechnen (116) folgende Schritte aufweist:

Anlegen (1160) der Prädiktionsinformationen (108) an das decodierte erste Kombinationssignal (112) oder an ein Signal (601), das von dem decodierten ersten Kombinationssignal abgeleitet ist, um ein Prädiktionssignal (1163) zu erhalten;

Berechnen (1161) eines zweiten Kombinationssignals (1165) durch Kombinieren des decodierten Restsignals (114) und des Prädiktionssignals (1163);

wobei das Anlegen (1160) ein Multiplizieren (1160b) des decodierten ersten Kombinationssignals mit dem reellwertigen Faktor eines Prädiktionskoeffizienten, um einen ersten Teil des Prädiktionssignals zu erhalten, aufweist,

wobei das Anlegen (1160) ein Schätzen (1160a) eines Imaginärteils (601) des decodierten ersten Kombinationssignals (112) unter Verwendung eines Realteils des decodierten ersten Kombinationssignals (112) aufweist,

wobei das Anlegen (1160) ein Multiplizieren (1161c) des Imaginärteils (601) des decodierten ersten Kombinationssignals mit dem Imaginärfaktor des Prädiktionskoeffizienten, um einen zweiten Teil des Prädiktionssignals zu erhalten, aufweist;

wobei das Berechnen (1161) ein lineares Kombinieren (1161a, 1161b) des ersten Teils des Prädiktionssignals und des zweiten Teils des Prädiktionssignals und des decodierten Restsignals, um ein zweites Kombinationssignal (1165) zu erhalten, aufweist; und

Kombinieren (1162) des decodierten ersten Kombinationssignals (112) und des zweiten Kombinationssignals (1165), um das decodierte Mehrkanalaudiosignal zu erhalten, das das decodierte Erster-Kanal-Signal (117) und das decodierte Zweiter-Kanal-Signal (118) aufweist,

wobei das codierte Mehrkanalsignal als Nebeninformationen einen reellen Indikator aufweist, der in einem ersten Zustand angibt, dass alle Prädiktionskoeffizienten für einen gewissen Rahmen des codierten Mehrkanalsignals reellwertig sind und keinen Imaginärabschnitt aufweisen, der sich von null unterscheidet, und der in einem zweiten Zustand angibt, dass Prädiktionskoeffizienten für einen Rahmen einen Imaginärabschnitt aufweisen, der sich von null unterscheidet,

wobei das Verfahren ferner ein Extrahieren des reellen Indikators aus dem codierten Mehrkanalaudiosignal (100) für den gewissen Rahmen aufweist, und

wobei der Imaginärteil (601) des decodierten ersten Kombinationssignals (112) für den gewissen Rahmen, für den der reelle Indikator den ersten Zustand aufweist, der lediglich reellwertige Prädiktionskoeffizienten für den gewissen Rahmen angibt, nicht berechnet wird.

**15.** Verfahren zum Codieren eines Mehrkanalaudiosignals, das Zwei- oder MehrKanal-Signale aufweist, wobei das Verfahren folgende Schritte aufweist:

Berechnen (203) eines ersten Kombinationssignals (204) und eines Prädiktionsrestsignals (205) unter Verwendung eines Erster-Kanal-Signals (201) und eines Zweiter-Kanal-Signals (202) und von Prädiktionsinformationen (206), die Prädiktionskoeffizienten für Rahmen aufweisen, so dass ein Prädiktionsrestsignal, wenn es mit einem von dem ersten Kombinationssignal abgeleiteten Prädiktionssignal oder mit einem Signal, das von dem ersten Kombinationssignal und den Prädiktionsinformationen (206) abgeleitet ist, kombiniert wird, zu einem zweiten Kombinationssignal (2032) führt, wobei das erste Kombinationssignal (204) und das zweite Kombinationssignal (2032) unter Verwendung einer Kombinationsregel von dem Erster-Kanal-Signal (201) und dem Zweiter-Kanal-Signal (202) ableitbar sind;

Berechnen (207) der Prädiktionsinformationen (206), die die Prädiktionskoeffizienten für die Rahmen aufweisen, so dass das Prädiktionsrestsignal (205) ein Optimierungsziel (208) erfüllt;

wobei das Berechnen (203) des ersten Kombinationssignals (204) und des Prädiktionsrestsignals (205) folgende Schritte aufweist:

Kombinieren (2031) des Erster-Kanal-Signals (201) und des Zweiter-Kanal-Signals (202) auf zwei unterschiedliche Weisen, um das erste Kombinationssignal (204) und das zweite Kombinationssignal (2032) zu erhalten;

Anlegen (2033) der Prädiktionsinformationen (206) an das erste Kombinationssignal (204) oder ein Signal (600), das von dem ersten Kombinationssignal (204) abgeleitet ist, um ein Prädiktionssignal (2035) zu erhalten; und

Berechnen (2034) des Prädiktionsrestsignals (205) durch Kombinieren des Prädiktionssignals (2035) und des zweiten Kombinationssignals (2032),

wobei das Anlegen (2033) folgende Schritte aufweist:

Multiplizieren (2073) des ersten Kombinationssignals (204) mit einem Realteil der Prädiktionsinformationen, um einen ersten Teil des Prädiktionssignals zu erhalten;

Schätzen (2070) eines Imaginärteils (600) des ersten Kombinationssignals unter Verwendung des ersten Kombinationssignals (204);

Multiplizieren (2074) des Imaginärteils des ersten Kombinationssignals mit einem Imaginärteil der Prädiktionsinformationen, um einen zweiten Teil des Prädiktionssignals zu erhalten; und

wobei das Berechnen (2034) des Prädiktionsrestsignals (205) ein lineares Kombinieren (2034a, 2034b) des ersten Teils des Prädiktionssignals und des zweiten Teils des Prädiktionssignals und des zweiten Kombinationssignals, um das Prädiktionsrestsignal (205) zu erhalten, aufweist;

Codieren (209) des ersten Kombinationssignals (204) und des Prädiktionsrestsignals (205), um ein codiertes erstes Kombinationssignal (210) und codiertes Restsignal (211) zu erhalten; und

Kombinieren (212) des codierten ersten Kombinationssignals (210), des codierten Prädiktionsrestsignals (211), der Prädiktionsinformationen (206) und eines reellen Indikators, der eine Situation angibt, in der alle Prädiktionskoeffizienten für einen gewissen Rahmen reelle Koeffizienten sind, um ein codiertes Mehrkanalaudiosignal zu erhalten.

16. Computerprogramm, das dazu angepasst ist, dann, wenn es auf einem Computer oder einem Prozessor läuft, das Verfahren gemäß Anspruch 14 oder das Verfahren gemäß Anspruch 15 auszuführen.

**Revendications**

1. Décodeur audio pour décoder un signal audio multicanal codé (100), le signal audio multicanal codé comprenant un premier signal de combinaison codé généré sur base d'une règle de combinaison pour combiner un signal audio de premier canal et un signal audio de deuxième canal d'un signal audio multicanal, un signal résiduel de prédiction codé et des informations de prédiction, comprenant:

un décodeur de signal (110) destiné à décoder le premier signal de combinaison codé (104) pour obtenir un premier signal de combinaison décodé (112), et à décoder le signal résiduel codé (106) pour obtenir un signal résiduel décodé (114); et

un calculateur de décodeur (116) destiné à calculer un signal multicanal décodé présentant un signal de premier canal décodé (117) et un signal de deuxième canal décodé (118) à l'aide du signal résiduel décodé (114), des informations de prédiction (108) et du premier signal de combinaison décodé (112), de sorte que le signal de premier canal décodé (117) et le signal de deuxième canal décodé (118) soient au moins des approximations du signal de premier canal et du signal de deuxième canal du signal multicanal, où les informations de prédiction (108) comprennent des coefficients de prédiction pour des trames, un coefficient de prédiction présentant un facteur à valeur réelle différent de zéro et un facteur imaginaire différent de zéro,

dans lequel le calculateur de décodeur (116) comprend:

un prédicteur (1160) destiné à appliquer les informations de prédiction (108) au premier signal de combinaison décodé (112) ou à un signal (601) dérivé du premier signal de combinaison décodé, pour obtenir un signal de prédiction (1163);

un calculateur de signal de combinaison (1161) destiné à calculer un deuxième signal de combinaison (1165) en combinant le signal résiduel décodé (114) et le signal de prédiction (1163);

dans lequel le prédicteur (1160) est configuré pour multiplier (1160b) le premier signal de combinaison décodé par le facteur à valeur réelle d'un coefficient de prédiction pour obtenir une première partie du signal de prédiction,

dans lequel le prédicteur (1160) est configuré pour estimer (1160a) une partie imaginaire (601) du premier signal de combinaison décodé (112) à l'aide d'une partie réelle du premier signal de combinaison décodé (112),

dans lequel le prédicteur (1160) est configuré pour multiplier (1161c) la partie imaginaire (601) du premier signal de combinaison décodé par le facteur imaginaire du coefficient de prédiction pour obtenir une deuxième partie du signal de prédiction;

dans lequel le calculateur de signal de combinaison (1161) est configuré pour combiner linéairement (1161a, 1161b) la première partie du signal de prédiction et la deuxième partie du signal de prédiction et le signal résiduel décodé, pour obtenir un deuxième signal de combinaison (1165); et

un combineur (1162) destiné à combiner le premier signal de combinaison décodé (112) et le deuxième signal de combinaison (1165), pour obtenir le signal audio multicanal décodé présentant le signal de premier canal décodé (117) et le signal de deuxième canal décodé (118),

dans lequel le signal multicanal codé comprend, comme informations latérales, un indicateur réel indiquant, dans un premier état, que tous les coefficients de prédiction pour une certaine trame du signal multicanal codé sont à valeur réelle et ne présentent pas de partie imaginaire différente de zéro, et indiquant, dans un deuxième état, que les coefficients de prédiction pour une trame comprennent une partie imaginaire différente de zéro, dans lequel le décodeur audio est configuré pour extraire l'indicateur réel du signal audio multicanal codé (100) pour la certaine trame, et

dans lequel le calculateur de décodeur (116) est configuré pour ne pas calculer la partie imaginaire (601) du premier signal de combinaison décodé (112) pour la certaine trame pour laquelle l'indicateur réel présente le premier état indiquant uniquement les coefficients de prédiction à valeur réelle pour la certaine trame.

2. Décodeur audio selon la revendication 1,
dans lequel le premier signal de combinaison codé (104) et le signal résiduel codé (106) ont été générés à l'aide d'une conversion temps-spectral générant un repliement,
dans lequel le décodeur comprend par ailleurs:

un convertisseur spectral-temps (52, 53) destiné à générer un signal de premier canal dans le domaine temporel et un signal de deuxième canal dans le domaine temporel à l'aide d'un algorithme de conversion spectral-temps correspondant à l'algorithme de conversion temps-spectral;

un processeur de recouvrement/addition (522) destiné à effectuer un traitement de recouvrement-addition pour le signal de premier canal dans le domaine temporel et le signal de deuxième canal dans le domaine temporel, pour obtenir un premier signal dans le domaine temporel exempt de repliement et un deuxième signal dans le domaine temporel exempt de repliement.

3. Décodeur audio selon l'une des revendications précédentes,
dans lequel le premier signal de combinaison codé ou décodé (104) et le signal résiduel de prédiction codé ou décodé (106) comprennent, chacun, une première pluralité de signaux de sous-bande,
dans lequel les informations de prédiction comprennent une deuxième pluralité de coefficients d'informations de prédiction, la deuxième pluralité étant plus petite que la première pluralité,
dans lequel le prédicteur (1160) est configuré pour appliquer le même coefficient de prédiction à au moins deux signaux de sous-bande différents du premier signal de combinaison décodé,
dans lequel le calculateur de décodeur (116) ou le calculateur de signal de combinaison (1161) ou le combineur (1162) sont configurés pour effectuer un traitement par sous-bande; et

dans lequel le décodeur audio comprend par ailleurs un banc de filtres de synthèse (52, 53) destiné à combiner les signaux de sous-bande du signal de premier canal décodé (117) et du signal de deuxième canal décodé (118) pour obtenir un signal de premier canal décodé dans le domaine temporel et un signal de deuxième canal décodé dans le domaine temporel.

4. Décodeur audio selon la revendication 1,
dans lequel le signal audio multicanal codé ne comprend pas de mots de code représentant une valeur zéro pour les parties imaginaires des coefficients de prédiction pour la certaine trame présentant l'indicateur réel indiquant le premier état, et
dans lequel une interface de décodeur de flux de bits est configurée pour interpréter l'indicateur réel de sorte que l'interface de décodeur de flux de bits ne recherche pas les mots de code pour les parties imaginaires des coefficients de prédiction pour la certaine trame et suppose que tous les bits se trouvant dans un segment correspondant d'un flux de bits représentant le signal multicanal codé sont des bits pour les coefficients de prédiction à valeur réelle pour la certaine trame.

5. Décodeur audio selon la revendication 1, configuré pour désactiver un élément effectuant l'estimation (1160a) de la partie imaginaire (601) du premier signal de combinaison décodé (112) pour la certaine trame présentant l'indicateur réel indiquant le premier état, et
dans lequel le calculateur de signal de combinaison (1161) est configuré pour combiner linéairement uniquement la première partie du signal de prédiction qui est obtenue en multipliant (1160b) le premier signal de combinaison décodé par le facteur à valeur réelle d'un coefficient de prédiction et le signal résiduel décodé pour obtenir le deuxième signal de combinaison (1165).

6. Décodeur audio selon la revendication 1, dans lequel l'indicateur réel est mis en oeuvre par un bit additionnel par trame, et dans lequel le décodeur est configuré pour lire le bit additionnel par trame pour décider si l'estimation (1160a) de la partie imaginaire (601) du premier signal de combinaison décodé (112) pour la certaine trame est active ou non pour une trame.

7. Codeur audio pour coder un signal audio multicanal présentant des signaux de deux ou plus de deux canaux, comprenant:

un calculateur de codeur (203) destiné à calculer un premier signal de combinaison (204) et un signal résiduel de prédiction (205) à l'aide d'un signal de premier canal (201) et d'un signal de deuxième canal (202) et des informations de prédiction (206) comprenant les coefficients de prédiction pour les trames, de sorte qu'un signal résiduel de prédiction, lorsqu'il est combiné avec un signal de prédiction dérivé du premier signal de combinaison ou un signal dérivé du premier signal de combinaison et des informations de prédiction (206), résulte en un deuxième signal de combinaison (2032), le premier signal de combinaison (204) et le deuxième signal de combinaison (2032) pouvant être dérivés du signal de premier canal (201) et du signal de deuxième canal (202) à l'aide d'une règle de combinaison;
un optimiseur (207) destiné à calculer les informations de prédiction (206) comprenant les coefficients de prédiction pour les trames de sorte que le signal résiduel de prédiction (205) remplisse une cible d'optimisation (208);
dans lequel le calculateur de codeur (203) comprend:

un combineur (2031) destiné à combiner le signal de premier canal (201) et le signal de deuxième canal (202) de deux manières différentes pour obtenir le premier signal de combinaison (204) et le deuxième signal de combinaison (2032);
un prédicteur (2033) destiné à appliquer les informations de prédiction (206) au premier signal de combinaison (204) ou à un signal (600) dérivé du premier signal de combinaison (204) pour obtenir un signal de prédiction (2035); et
un calculateur de signal résiduel (2034) destiné à calculer le signal résiduel de prédiction (205) en combinant le signal de prédiction (2035) et le deuxième signal de combinaison (2032),

dans lequel le prédicteur (2033) est configuré pour

multiplier (2073) le premier signal de combinaison (204) par une partie réelle des informations de prédiction pour obtenir une première partie du signal de prédiction;
estimer (2070) une partie imaginaire (600) du premier signal de combinaison à l'aide du premier signal de combinaison (204);
multiplier (2074) la partie imaginaire du premier signal de combinaison par une partie imaginaire des informations de prédiction pour obtenir une deuxième partie du signal de prédiction; et

dans lequel le calculateur de résiduel (2034) est configuré pour combiner linéairement (2034a, 2034b) la première partie du signal de prédiction et la deuxième partie du signal de prédiction et le deuxième signal de combinaison pour obtenir le signal résiduel de prédiction (205);
un codeur de signal (209) destiné à coder le premier signal de combinaison (204) et le signal résiduel de prédiction (205) pour obtenir un premier signal de combinaison codé (210) et un signal résiduel codé (211); et
une interface de sortie (212) destinée à combiner le premier signal de combinaison codé (210), le signal résiduel de prédiction codé (211), les informations de prédiction (206), et un indicateur réel indiquant une situation où tous les coefficients de prédiction pour une certaine trame sont des coefficients réels, pour obtenir un signal audio multicanal codé, et dans lequel le signal audio multicanal codé ne comprend pas de mots de code représentant une valeur zéro pour les parties imaginaires des coefficients de prédiction pour la certaine trame présentant l'indicateur réel.

8. Codeur audio selon la revendication 7, dans lequel le prédicteur (2033) comprend un quantificateur destiné à quantifier le signal de premier canal, le signal de deuxième canal, le premier signal de combinaison ou le deuxième signal de combinaison pour obtenir un ou plusieurs signaux quantifiés, et dans lequel le prédicteur (2033) est configuré pour calculer le signal résiduel à l'aide des signaux quantifiés.

9. Codeur audio selon l'une des revendications 7 à 8,
dans lequel le signal de premier canal est une représentation spectrale d'un bloc d'échantillons;
dans lequel le signal de deuxième canal est une représentation spectrale d'un bloc d'échantillons,
dans lequel les représentations spectrales sont des représentations spectrales réelles pures,
dans lequel l'optimiseur (207) est configuré pour calculer les informations de prédiction (206) comme facteur de valeur réelle différent de zéro et comme facteur imaginaire différent de zéro, et
dans lequel le calculateur de codeur (203) est configuré pour calculer le premier signal de combinaison et le signal résiduel de prédiction de sorte que le signal de prédiction soit dérivé de la représentation spectrale réelle pure à l'aide du facteur à valeur réelle.

10. Codeur audio selon l'une des revendications 7 à 9,
dans lequel le signal de premier canal est une représentation spectrale d'un bloc d'échantillons;
dans lequel le signal de deuxième canal est une représentation spectrale d'un bloc d'échantillons,
dans lequel les représentations spectrales sont des représentations spectrales réelles pures,
dans lequel l'optimiseur (207) est configuré pour calculer les information de prédiction (206) comme facteur de valeur réelle différent de zéro et comme facteur imaginaire différent de zéro, et
dans lequel le calculateur de codeur (203) comprend un transformateur réel-imaginaire (2070) destiné à estimer (2070) la partie imaginaire (600) du premier signal de combinaison.

11. Codeur audio selon la revendication 7, configuré pour désactiver un élément effectuant l'estimation (2070) de la partie imaginaire (600) du premier signal de combinaison (204) pour la certaine trame présentant l'indicateur réel, et dans lequel le calculateur de résidu (2034) est configuré pour combiner linéairement (2034) uniquement la première partie du signal de prédiction qui est obtenue en multipliant (2073) le premier signal de combinaison par la partie à valeur réelle d'un coefficient de prédiction et le deuxième signal de combinaison pour obtenir le signal résiduel.

12. Codeur audio selon la revendication 7, dans lequel l'indicateur réel est mis en oeuvre par un bit additionnel par trame, et dans lequel le codeur audio est configuré pour placer le bit additionnel par trame dans les informations latérales pour indiquer si l'estimation (2017) de la partie imaginaire (600) du premier signal de combinaison (112) est active ou non pour une trame.

13. Codeur audio selon la revendication 7, dans lequel l'indicateur réel est un élément de données associé à chaque trame indiquant, dans un premier état, que tous les coefficients de prédiction pour une trame sont uniquement à valeur réelle et indiquant, dans un deuxième état, que les parties imaginaires pour les coefficients de prédiction sont transmises pour toutes les bandes de prédiction.

14. Procédé de décodage d'un signal audio multicanal codé (100), le signal audio multicanal codé comprenant un premier signal de combinaison codé généré sur base d'une règle de combinaison pour combiner un signal audio de premier canal et un signal audio de deuxième canal d'un signal audio multicanal, un signal résiduel de prédiction codé et des informations de prédiction, comprenant le fait de:

décoder (110) le premier signal de combinaison codé (104) pour obtenir un premier signal de combinaison décodé (112), et décoder le signal résiduel codé (106) pour obtenir un signal résiduel décodé (114); et

calculer (116) un signal multicanal décodé présentant un signal de premier canal décodé (117) et un signal de deuxième canal décodé (118) à l'aide du signal résiduel décodé (114), des informations de prédiction (108) et du premier signal de combinaison décodé (112), de sorte que le signal de premier canal décodé (117) et le signal de deuxième canal décodé (118) soient au moins des approximations du signal de premier canal et du signal de deuxième canal du signal multicanal, où les informations de prédiction (108) comprennent des coefficients de prédiction pour les trames, un coefficient de prédiction présentant un facteur à valeur réelle différent de zéro et un facteur imaginaire différent de zéro,

dans lequel le calcul (116) comprend le fait de:

appliquer (1160) les informations de prédiction (108) au premier signal de combinaison décodé (112) ou à un signal (601) dérivé du premier signal de combinaison décodé, pour obtenir un signal de prédiction (1163);

calculer (1161) un deuxième signal de combinaison (1165) en combinant le signal résiduel décodé (114) et le signal de prédiction (1163);

dans lequel l'application (1160) comprend le fait de multiplier (1160b) le premier signal de combinaison décodé par le facteur à valeur réelle d'un coefficient de prédiction pour obtenir une première partie du signal de prédiction,

dans lequel l'application (1160) comprend le fait d'estimer (1160a) une partie imaginaire (601) du premier signal de combinaison décodé (112) à l'aide d'une partie réelle du premier signal de combinaison décodé (112),

dans lequel l'application (1160) comprend le fait de multiplier (1161c) la partie imaginaire (601) du premier signal de combinaison décodé par le facteur imaginaire du coefficient de prédiction pour obtenir une deuxième partie du signal de prédiction;

dans lequel le calcul (1161) comprend le fait de combiner linéairement (1161a, 1161b) la première partie du signal de prédiction et la deuxième partie du signal de prédiction et le signal résiduel décodé, pour obtenir un deuxième signal de combinaison (1165); et

combiner (1162) le premier signal de combinaison décodé (112) et le deuxième signal de combinaison (1165) pour obtenir le signal audio multicanal décodé présentant le signal de premier canal décodé (117) et le signal deuxième de canal décodé (118),

dans lequel le signal multicanal codé comprend, comme informations latérales, un indicateur réel indiquant, dans un premier état, que tous les coefficients de prédiction pour une certaine trame du signal multicanal codé sont à valeur réelle et ne présentent pas de partie imaginaire différente de zéro, et indiquant, dans un deuxième état, que les coefficients de prédiction pour une trame comprennent une partie imaginaire différente de zéro,

dans lequel le procédé comprend par ailleurs le fait d'extraire l'indicateur réel du signal audio multicanal codé (100) pour la certaine trame, et

dans lequel la partie imaginaire (601) du premier signal de combinaison décodé (112) n'est pas calculée pour la certaine trame pour laquelle l'indicateur réel présente le premier état indiquant uniquement des coefficients de prédiction à valeur réelle pour la certaine trame.

**15.** Procédé de codage d'un signal audio multicanal présentant des signaux de deux ou plus de deux canaux, comprenant le fait de:

calculer (203) un premier signal de combinaison (204) et un signal résiduel de prédiction (205) à l'aide d'un signal de premier canal (201) et d'un signal de deuxième canal (202) et des informations de prédiction (206) comprenant les coefficients de prédiction pour les trames, de sorte qu'un signal résiduel de prédiction, lorsqu'il est combiné avec un signal de prédiction dérivé du premier signal de combinaison ou un signal dérivé du premier signal de combinaison et des informations de prédiction (206), résulte en un deuxième signal de combinaison (2032), le premier signal de combinaison (204) et le deuxième signal de combinaison (2032) pouvant être dérivés du signal de premier canal (201) et du signal de deuxième canal (202) à l'aide d'une règle de combinaison;

calculer (207) les informations de prédiction (206) comprenant les coefficients de prédiction pour les trames, de sorte que le signal résiduel de prédiction (205) remplisse une cible d'optimisation (208);

dans lequel le calcul (203) du premier signal de combinaison (204) et du signal résiduel de prédiction (205) comprend le fait de:

combiner (2031) le signal de premier canal (201) et le signal de deuxième canal (202) de deux manières différentes pour obtenir le premier signal de combinaison (204) et le deuxième signal de combinaison (2032);
appliquer (2033) les informations de prédiction (206) au premier signal de combinaison (204) ou à un signal (600) dérivé du premier signal de combinaison (204) pour obtenir un signal de prédiction (2035); et
calculer (2034) le signal résiduel de prédiction (205) en combinant le signal de prédiction (2035) et le deuxième signal de combinaison (2032),

dans lequel l'application (2033) comprend le fait de

multiplier (2073) le premier signal de combinaison (204) par une partie réelle des informations de prédiction pour obtenir une première partie du signal de prédiction;
estimer (2070) une partie imaginaire (600) du premier signal de combinaison à l'aide du premier signal de combinaison (204);
multiplier (2074) la partie imaginaire du premier signal de combinaison par une partie imaginaire des informations de prédiction pour obtenir une deuxième partie du signal de prédiction; et

dans lequel le calcul (2034) du signal résiduel de prédiction (205) comprend le fait de combiner linéairement (2034a, 2034b) la première partie du signal de prédiction et la deuxième partie du signal de prédiction et le deuxième signal de combinaison pour obtenir le signal résiduel de prédiction (205);
coder (209) le premier signal de combinaison (204) et le signal résiduel de prédiction (205) pour obtenir un premier signal de combinaison codé (210) et un signal résiduel codé (211); et

combiner (212) le premier signal de combinaison codé (210), le signal résiduel de prédiction codé (211), les informations de prédiction (206) et un indicateur réel indiquant une situation où tous les coefficients de prédiction pour une certaine trame sont des coefficients réels, pour obtenir un signal audio multicanal codé.

16. Programme d'ordinateur adapté pour réaliser, lorsqu'il est exécuté sur un ordinateur ou un processeur, le procédé selon la revendication 14 ou le procédé selon la revendication 15.

EP 2 947 657 B1

**FIGURE 1**
(AUDIO DECODER)

$$\alpha = \frac{<S,M>}{\|M\|^2} \; ; \; \|S-\alpha M\|^2 \overset{!}{=} \min;$$

or: •perceptual quality
•bitrate (minimum or fixed)
•minimum coder resources

FIGURE 2
(AUDIO ENCODER)

EP 2 947 657 B1

FIGURE 3A
(AUDIO ENCODER SIDE)

$$\alpha = \mathrm{Re}_{\alpha} + j\mathrm{Im}_{\alpha}$$

$$\alpha = (\alpha) \cdot e^{j\varphi_{\alpha}}$$

1st part: $\mathrm{Re}_{\alpha}$ or $(\alpha)$

2nd part : $\mathrm{Im}_{\alpha}$ or $\varphi_{\alpha}$

$$\begin{bmatrix} M \\ D \end{bmatrix} = \frac{1}{2} \begin{bmatrix} 1 & 1 \\ 1-\alpha & -1-\alpha \end{bmatrix} \begin{bmatrix} L \\ R \end{bmatrix}$$

# FIGURE 3B
## (AUDIO ENCODER SIDE)

$$M = \frac{1}{2}(L+R)$$

$$S = \frac{1}{2}(L-R)$$

# FIGURE 3C
## (COMBINATION RULE)

FIGURE 4A
(AUDIO DECODER SIDE)

$$\begin{bmatrix} L \\ R \end{bmatrix} = \begin{bmatrix} 1+\alpha & 1 \\ 1-\alpha & -1 \end{bmatrix} \begin{bmatrix} M \\ D \end{bmatrix}$$

FIGURE 4B
(AUDIO DECODER SIDE)

$L = M + S$

$R = M - S$

FIGURE 4C
(INVERSE COMBINATION RULE)

$S = \alpha \cdot M + D$

$D = S - \alpha M$

FIGURE 5A
(ENCODER SIDE)

FIGURE 5B
(DECODER SIDE)

**FIGURE 6A**
**(ENCODER SIDE)**

FIGURE 6B
(DECODER SIDE)

FIGURE 7A

$$\begin{bmatrix} L \\ R \end{bmatrix} = g \begin{bmatrix} 1 & 1 \\ 1 & -1 \end{bmatrix} \begin{bmatrix} DMX \\ RES \end{bmatrix}$$

FIGURE 7B

**FIGURE 8A**

502 — time domain sequence of samples → analysis windower (e.g. 50% stride/overlap) 500

window/transform length control

→ MDCT transform 501 → sequence of real-valued MDCT frames (aliasing-affected)

**FIGURE 8B**

sequence of MDCT frames (aliasing-affected) → MDCT⁻¹ transform 520

window/transform length control 523

→ synthesis windower 521 → overlap/add processor 522 (e.g. 50% overlap) → aliasing free signal

frequ.
resol.

low
frequ.
resol.

50

90

207

α for bands
only, i.e. at
low reso-
lution

spectral
converter
(MDCT
processor)

spectral
line
selector

optimizer

or: - filterbank with increasing
bandwidths
- or equally-sized
frequ.bands each having
at least two spectr.lines

FIGURE 9A

A(f)

spectral lines

. . .

. . .

k

B1    B2    B3    . . .    BN
              . . .

- only a single α is calculated for each band
(e.g. - 1024 spectral lines;
        - less than 30 complex α-values (e.g. 22))
- Bi increase with frequency

FIGURE 9B

EP 2 947 657 B1

FIGURE 10A

1008      real lines $F_i$

1005      real lines $F_{i-1}$

1006      real lines $F_{i+1}$

| weighted combination of lines in current frame around the current line k (e.g. 2-15 taps) | weighted combination of lines in frame (i-1) around the current line k | weighted combination of lines in frame (i+1) around the current line k |

weights:
FIR filter
coefficients

weighted combination of results

imaginary line k for frame $F_i$

1007

FIGURE 10B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2011124608 A1
- WO 2009141775 A1
- WO 2004013839 A1
- WO 2008014853 A1
- US 6980933 B

**Non-patent literature cited in the description**

- **HEIKO PURNHAGEN et al.** Technical description of proposed Unified Stereo Coding in USAC. *90. MPEG MEETING; 26-10-2009 - 30-10-2009; XIAN; (MOTION PICTURE EXPERT GROUP OR ISO/IEC JTC1/ SC29/WG11),* 23 October 2009
- WD5 of USAC. 90. MPEG MEETING; 26-10-2009 - 30-10-2009; XIAN. MOTION PICTURE EXPERT GROUP, 08 December 2009, 1-146